(19) Europäisches Patentamt

European Patent Office

Office européen des brevets

(11) **EP 4 672 613 A2**

(12) **EUROPEAN PATENT APPLICATION**

(43) Date of publication:
**31.12.2025 Bulletin 2026/01**

(21) Application number: 25173199.8

(22) Date of filing: **29.04.2025**

(51) International Patent Classification (IPC):
**H03M 1/12** *(2006.01)*    **H03M 1/50** *(2006.01)*

(52) Cooperative Patent Classification (CPC):
**H03M 1/1215; H03M 1/1245; H03M 1/50**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **28.06.2024 US 202418757646**

(71) Applicant: **Intel Corporation**
**Santa Clara, CA 95054 (US)**

(72) Inventors:
• **CARLTON, Brent**
  **Portland, 97229 (US)**

• **WHITCOMBE, Amy**
  **Saratoga, 95070 (US)**
• **DORRANCE, Richard**
  **Beaverton, 97006 (US)**
• **KURAHASHI, Peter**
  **Fort Collins (US)**
• **WANG, Hechen**
  **Hillsboro (US)**

(74) Representative: **Viering, Jentschura & Partner mbB**
**Patent- und Rechtsanwälte**
**Am Brauhaus 8**
**01099 Dresden (DE)**

(54) **METHODS AND DEVICES FOR TIME DOMAIN ADC SAMPLING AND FILTERING**

(57)    An analog to digital converter (ADC) circuit including: a voltage-controlled delay circuit (VCDC) configured to: sample a received analog signal based on an input clock signal to generate analog signal samples; generate an output signal representative of the input clock signal shifted in the time domain with a delay based on the analog signal samples; and a time to digital converter (TDC) coupled to the voltage-controlled delay circuit and configured to generate a digital output signal based on the output signal.

FIG. 8

Processed by Luminess, 75001 PARIS (FR)

**Description**

**Technical Field**

Various embodiments relate generally to an analog-to-digital converter (ADC) circuit and signal sampling.

**Background**

Fast (e.g. sampling rate>10 GS/s) ADCs may play a key role in high-speed communication systems. However, extending the bandwidth of such ADCs at high sample rates may pose significant challenges, such as the minimum sampling capacitance and/or large input signal swing required to reduce thermal noise. Furthermore, power-hungry input buffers may be typically necessary to drive the sampling switch, which may be detrimental to the system efficiency. In scaled process technologies, maintaining high bandwidth may be particularly difficult, where reduced voltage headroom may increase the signal-dependent switch resistance that may affect ADC linearity and achievable bandwidth.

**Brief Description of the Drawings**

In the drawings, like reference characters generally refer to the same parts throughout the different views. The drawings are not necessarily to scale, emphasis instead generally being placed upon illustrating the principles of the invention. In the following description, various embodiments of the invention are described with reference to the following drawings, in which:

FIG. 1 shows an example of a communication network;
FIG. 2 shows an example of a communication device
FIG. 3 shows an example of an ADC circuit in accordance with various aspects of the disclosure.
FIG. 4 shows an example of an ADC circuit.
FIG. 5 shows an example of a current-starved inverter.
FIG.6A shows an example of a voltage-controlled delay circuit.
FIG. 6B shows an example of a timing diagram of the voltage-controlled delay circuit.
FIG. 7 shows an example of a time-based ADC circuit for analog signal sampling.
FIG. 8 shows an example of a transistor-level implementation of a current starved delay element in accordance with various aspects of the disclosure.
FIG. 9 shows an example of a transistor-level implementation of a current-starved delay element in accordance with various aspects of the disclosure.
FIG. 10 shows an example of a transistor-level implementation of a current-starved delay element in accordance with various aspects of the disclosure.
FIG. 11 shows an example of a time-interleaved ADC.
FIGs. 12A, 12B and 12C show exemplary simulation results in accordance with various aspects of the disclosure.
FIGs. 13A and 13B show exemplary simulation results.
FIGs. 14A and FIG. 14B show exemplary simulation results in accordance with various aspects of the disclosure.
FIG. 15 shows an example of ADC circuit.
FIG. 16 shows an example of hybrid voltage-controlled delay circuit (VCDC) and time-to-voltage converter (TVC) implementation.
FIGs. 17A and FIG. 17B show an example of time-interleaving methodology in accordance with various aspects disclosed herein.
FIG. 18 shows an example of a simulation result.
FIG. 19 shows an example of 3-tap FIR filter in accordance with various aspects of the disclosure.
FIG. 20 shows an example of a simulation result.
FIG. 21 shows an example of N-tap FIR filter in accordance with various aspects of the disclosure.
FIG. 22 shows an example of simulation results.

**Description**

The following detailed description refers to the accompanying drawings that show, by way of illustration, specific details and embodiments in which the invention may be practiced.

The word "exemplary" is used herein to mean "serving as an example, instance, or illustration". Any embodiment or design described herein as "exemplary" is not necessarily to be construed as preferred or advantageous over other embodiments or designs.

The term "delay" may refer to a time difference between two signals (e.g. two digital transitions). A delay may correspond to a phase shift relative to a reference signal. In some examples described herein, a delay may refer to a phase shift or a time difference relative to an input clock signal, unless indicated otherwise.

The term "single-ended output implementation" may refer to or include a single-ended delay line in which an input analog signal may be a single-ended voltage signal converted into a time delay using a voltage-to-time converter.

The term "differential delay output implementation" may refer to or include a differential delay line in which the input analog signal may be a differential voltage signal instead of a single-ended signal.

The term "ADC circuit" may refer to a circuit configured to convert an analog signal into a digital signal. In accordance with various aspects described herein, an ADC circuit may or include circuitry including one or more of a voltage-to-time converter, time-to-voltage converter, time-to-digital converter, analog-to-digital converter, and the like.

The apparatuses and methods of this disclosure may utilize or be related to radio communication technologies. While some examples may refer to specific radio communication technologies, the examples provided herein may be similarly applied to various other radio communication technologies, both existing and not yet formulated, particularly in cases where such radio communication technologies share similar features as disclosed regarding the following examples. Various exemplary radio communication technologies that the apparatuses and methods described herein may utilize include, but are not limited to: a Global System for Mobile Communications ("GSM") radio communication technology, a General Packet Radio Service ("GPRS") radio communication technology, an Enhanced Data Rates for GSM Evolution ("EDGE") radio communication technology, and/or a Third Generation Partnership Project ("3GPP") radio communication technology, for example Universal Mobile Telecommunications System ("UMTS"), Freedom of Multimedia Access ("FOMA"), 3GPP Long Term Evolution ("LTE"), 3GPP Long Term Evolution Advanced ("LTE Advanced"), Code division multiple access 2000 ("CDMA2000"), Cellular Digital Packet Data ("CDPD"), Mobitex, Third Generation (3G), Circuit Switched Data ("CSD"), High-Speed Circuit-Switched Data ("HSCSD"), Universal Mobile Telecommunications System ("Third Generation") ("UMTS (3G)"), Wideband Code Division Multiple Access (Universal Mobile Telecommunications System) ("W-CDMA (UMTS)"), High Speed Packet Access ("HSPA"), High-Speed Downlink Packet Access ("HSDPA"), High-Speed Uplink Packet Access ("HSUPA"), High Speed Packet Access Plus ("HSPA+"), Universal Mobile Telecommunications System-Time-Division Duplex ("UMTS-TDD"), Time Division-Code Division Multiple Access ("TD-CDMA"), Time Division-Synchronous Code Division Multiple Access ("TD-CDMA"), 3rd Generation Partnership Project Release 8 (Pre-4th Generation) ("3GPP Rel. 8 (Pre-4G)"), 3GPP Rel. 9 (3rd Generation Partnership Project Release 9), 3GPP Rel. 10 (3rd Generation Partnership Project Release 10), 3GPP Rel. 11 (3rd Generation Partnership Project Release 11), 3GPP Rel. 12 (3rd Generation Partnership Project Release 12), 3GPP Rel. 13 (3rd Generation Partnership Project Release 13), 3GPP Rel. 14 (3rd Generation Partnership Project Release 14), 3GPP Rel. 15 (3rd Generation Partnership Project Release 15), 3GPP Rel. 16 (3rd Generation Partnership Project Release 16), 3GPP Rel. 17 (3rd Generation Partnership Project Release 17), 3GPP Rel. 18 (3rd Generation Partnership Project Release 18), 3GPP 5G, 3GPP LTE Extra, LTE-Advanced Pro, LTE Licensed-Assisted Access ("LAA"), MuLTEfire, UMTS Terrestrial Radio Access ("UTRA"), Evolved UMTS Terrestrial Radio Access ("E-UTRA"), Long Term Evolution Advanced (4th Generation) ("LTE Advanced (4G)"), cdmaOne ("2G"), Code division multiple access 2000 (Third generation) ("CDMA2000 (3G)"), Evolution-Data Optimized or Evolution-Data Only ("EV-DO"), Advanced Mobile Phone System (1st Generation) ("AMPS (1G)"), Total Access Communication arrangement/Extended Total Access Communication arrangement ("TACS/ETACS"), Digital AMPS (2nd Generation) ("D-AMPS (2G)"), Push-to-talk ("PTT"), Mobile Telephone System ("MTS"), Improved Mobile Telephone System ("IMTS"), Advanced Mobile Telephone System ("AMTS"), OLT (Norwegian for Offentlig Landmobil Telefoni, Public Land Mobile Telephony), MTD (Swedish abbreviation for Mobiltelefonisystem D, or Mobile telephony system D), Public Automated Land Mobile ("Autotel/PALM"), ARP (Finnish for Autoradiopuhelin, "car radio phone"), NMT (Nordic Mobile Telephony), High capacity version of NTT (Nippon Telegraph and Telephone) ("Hicap"), Cellular Digital Packet Data ("CDPD"), Mobitex, DataTAC, Integrated Digital Enhanced Network ("iDEN"), Personal Digital Cellular ("PDC"), Circuit Switched Data ("CSD"), Personal Handy-phone System ("PHS"), Wideband Integrated Digital Enhanced Network ("WiDEN"), iBurst, Unlicensed Mobile Access ("UMA"), also referred to as also referred to as 3GPP Generic Access Network, or GAN standard), Zigbee, Bluetooth®, Wireless Gigabit Alliance ("WiGig") standard, mmWave standards in general (wireless systems operating at 10-300 GHz and above such as WiGig, IEEE 802.11ad, IEEE 802.11ay, etc.), technologies operating above 300 GHz and THz bands, (3GPP/LTE based or IEEE 802.11p and other) Vehicle-to-Vehicle ("V2V") and Vehicle-to-X ("V2X") and Vehicle-to-Infrastructure ("V2I") and Infrastructure-to-Vehicle ("I2V") communication technologies, 3GPP cellular V2X, DSRC (Dedicated Short Range Communications) communication arrangements such as Intelligent Transport-Systems, and other existing, developing, or future radio communication technologies.

The apparatuses and methods described herein may use such radio communication technologies according to various spectrum management schemes, including, but not limited to, dedicated licensed spectrum, unlicensed spectrum, (licensed) shared spectrum (such as LSA = Licensed Shared Access in 2.3-2.4 GHz, 3.4-3.6 GHz, 3.6-3.8 GHz and further frequencies and SAS = Spectrum Access System in 3.55-3.7 GHz and further frequencies), and may use various spectrum bands including, but not limited to, IMT (International Mobile Telecommunications) spectrum (including 450-470 MHz, 790 960 MHz, 1710 2025 MHz, 2110-2200 MHz, 2300-2400 MHz, 2500-2690 MHz, 698 790 MHz, 610 790 MHz, 3400 3600 MHz, etc., where some bands may be limited to specific region(s) and/or countries), IMT advanced spectrum, IMT-2020 spectrum (expected to include 3600 3800 MHz, 3.5 GHz bands, 700 MHz bands, bands within the 24.25 86 GHz range, etc.), spectrum made available under FCC's "Spectrum Frontier" 5G initiative (including 27.5-28.35 GHz, 29.1-29.25 GHz, 31-31.3 GHz, 37-38.6 GHz, 38.6-40 GHz, 42-42.5 GHz, 57-64 GHz, 64-71 GHz, 71-76 GHz, 81-86 GHz and 92-94 GHz, etc.), the ITS (Intelligent Transport Systems) band of 5.9 GHz (typically 5.85 5.925 GHz) and 63 64 GHz, bands currently allocated to WiGig such as WiGig Band 1 (57.24 59.40 GHz), WiGig Band 2 (59.40 61.56 GHz) and WiGig Band 3 (61.56 63.72 GHz) and WiGig Band 4 (63.72 65.88 GHz), the 70.2 GHz-71 GHz band, any band between 65.88 GHz and 71 GHz, bands currently allocated to automotive radar applications such as 76 81 GHz, and future bands including 94 300 GHz and above. Furthermore, the apparatuses and methods described herein can also employ radio communication technologies on a secondary basis on bands such as the TV White Space bands (typically below 790 MHz) where e.g. the 400 MHz and 700 MHz bands are prospective candidates. Besides cellular applications, specific applications for vertical markets may be addressed such as PMSE (Program Making and Special Events), medical, health, surgery, automotive, low-latency, drones, etc. applications. Furthermore, the apparatuses and methods described herein may also use radio communication technologies with a hierarchical application, such as by introducing a hierarchical prioritization of usage for different types of users (e.g., low/medium/high priority, etc.), based on a prioritized access to the spectrum e.g., with highest priority to tier 1 users, followed by tier 2, then tier 3, etc. users, etc. The apparatuses and methods described herein can also use radio communication technologies with different Single Carrier or OFDM flavors (CP OFDM, SC FDMA, SC OFDM, filter bank-based multicarrier (FBMC), OFDMA, etc.) and e.g. 3GPP NR (New Radio), which can include allocating the OFDM carrier data bit vectors to the corresponding symbol resources.

For purposes of this disclosure, radio communication technologies may be classified as one of a Short Range radio communication technology or Cellular Wide Area radio communication technology. Short Range radio communication technologies may include Bluetooth, WLAN (e.g., according to any IEEE 802.11 standard), and other similar radio communication technologies. Cellular Wide Area radio communication technologies may include Global System for Mobile Communications ("GSM"), Code Division Multiple Access 2000 ("CDMA2000"), Universal Mobile Telecommunications System ("UMTS"), Long Term Evolution ("LTE"), General Packet Radio Service ("GPRS"), Evolution-Data Optimized ("EV-DO"), Enhanced Data Rates for GSM Evolution ("EDGE"), High Speed Packet Access (HSPA; including High Speed Downlink Packet Access ("HSDPA"), High Speed Uplink Packet Access ("HSUPA"), HSDPA Plus ("HSDPA+"), and HSUPA Plus ("HSUPA+")), Worldwide Interoperability for Microwave Access ("WiMax") (e.g., according to an IEEE 802.16 radio communication standard, e.g., WiMax fixed or WiMax mobile), etc., and other similar radio communication technologies. Cellular Wide Area radio communication technologies also include "small cells" of such technologies, such as microcells, femtocells, and picocells. Cellular Wide Area radio communication technologies may be generally referred to herein as "cellular" communication technologies.

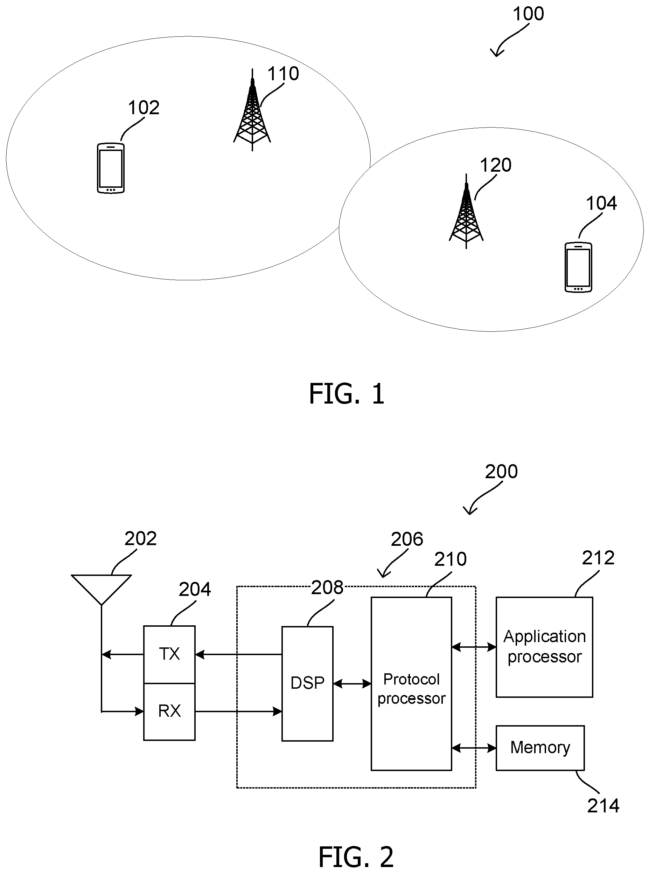

FIGs. 1 and 2 depict a general network and device architecture for wireless communications, including in particular aspects of a mobile communication network. In particular, FIG. 1 shows exemplary radio communication network 100 according to some aspects, which may include terminal devices 102 and 104 and network access nodes 110 and 120. Radio communication network 100 may communicate with terminal devices 102 and 104 via network access nodes 110 and 120 over a radio access network. Although certain examples described herein may refer to a particular radio access network context (e.g., LTE, UMTS, GSM, other 3rd Generation Partnership Project (3GPP) networks, WLAN/WiFi, Bluetooth, 5G NR, mmWave, etc.), these examples are demonstrative and may therefore be readily applied to any other type or configuration of radio access network. The number of network access nodes and terminal devices in radio communication network 100 is exemplary and is scalable to any amount.

In an exemplary cellular context, network access nodes 110 and 120 may be base stations (e.g., eNodeBs, NodeBs, Base Transceiver Stations (BTSs), gNodeBs, or any other type of base station), while terminal devices 102 and 104 may be cellular terminal devices (e.g., Mobile Stations (MSs), User Equipments (UEs), or any type of cellular terminal device). Network access nodes 110 and 120 may therefore interface (e.g., via backhaul interfaces) with a cellular core network such as an Evolved Packet Core (EPC, for LTE), Core Network (CN, for UMTS), or other cellular core networks, which may also be considered part of radio communication network 100. The cellular core network may interface with one or more external data networks. In an exemplary short-range context, network access node 110 and 120 may be access points (APs, e.g., WLAN or WiFi APs), while terminal device 102 and 104 may be short range terminal devices (e.g., stations (STAs)). Network access nodes 110 and 120 may interface (e.g., via an internal or external router) with one or more external data networks. Network access nodes 110 and 120 and terminal devices 102 and 104 may include one or multiple transmission/reception points (TRPs).

Network access nodes 110 and 120 (and, optionally, other network access nodes of radio communication network 100 not explicitly shown in FIG. 1) may accordingly provide a radio access network to terminal devices 102 and 104 (and, optionally, other terminal devices of radio communication network 100 not explicitly shown in FIG. 1). In an exemplary cellular context, the radio access network provided by network access nodes 110 and 120 may enable terminal devices 102 and 104 to wirelessly access the core network via radio communications. The core network may provide switching, routing, and transmission, for traffic data related to terminal devices 102 and 104, and may further provide access to various internal data networks (e.g., control nodes, routing nodes that transfer information between other terminal devices on radio communication network 100, etc.) and external data networks (e.g., data networks providing voice, text, multimedia (audio, video, image), and other Internet and application data). In an exemplary short-range context, the radio access network provided by network access nodes 110 and 120 may provide access to internal data networks (e.g., for transferring data between terminal devices connected to radio communication network 100) and external data networks (e.g., data networks providing voice, text, multimedia (audio, video, image), and other Internet and application data).

The radio access network and core network (if applicable, such as for a cellular context) of radio communication network 100 may be governed by communication protocols that can vary depending on the specifics of radio communication network 100. Such communication protocols may define the scheduling, formatting, and routing of both user and control data traffic through radio communication network 100, which includes the transmission and reception of such data through both the radio access and core network domains of radio communication network 100. Accordingly, terminal devices 102 and 104 and network access nodes 110 and 120 may follow the defined communication protocols to transmit and receive data over the radio access network domain of radio communication network 100, while the core network may follow the defined communication protocols to route data within and outside of the core network. Exemplary communication protocols include LTE, UMTS, GSM, WiMAX, Bluetooth, WiFi, mmWave, etc., any of which may be applicable to radio communication network 100.

FIG. 2 shows an exemplary internal configuration of a communication device according to various aspects provided in this disclosure. The communication device may include a terminal device 102, and it will be referred to as communication device 200, but the communication device may also include various aspects of network access nodes 110, 120 as well. In some examples, the communication device 200 may be a further entity within the radio communication network 100, which may communicate with multiple network access nodes 110, 120. The communication device 200 may include antenna system 202, radio frequency (RF) transceiver 204, baseband modem 206 (including digital signal processor 208 and protocol controller 210), application processor 212, and memory 214. Although not explicitly shown in FIG. 2, in some aspects communication device 200 may include one or more additional hardware and/or software components, such as processors/microprocessors, controllers/microcontrollers, other specialty or generic hardware/-processors/circuits, peripheral device(s), memory, power supply, external device interface(s), subscriber identity module(s) (SIMs), user input/output devices (display(s), keypad(s), touchscreen(s), speaker(s), external button(s), camera(s), microphone(s), etc.), or other related components.

Communication device 200 may transmit and receive radio signals on one or more radio access networks. Baseband modem 206 may direct such communication functionality of communication device 200 according to the communication protocols associated with each radio access network, and may execute control over antenna system 202 and RF transceiver 204 to transmit and receive radio signals according to the formatting and scheduling parameters defined by each communication protocol. Although various practical designs may include separate communication components for each supported radio communication technology (e.g., a separate antenna, RF transceiver, digital signal processor, and controller), for purposes of conciseness, the configuration of communication device 200 shown in FIG. 2 depicts only a single instance of such components.

Communication device 200 may transmit and receive wireless signals with antenna system 202. Antenna system 202 may be a single antenna or may include one or more antenna arrays that each include multiple antenna elements. For example, antenna system 202 may include an antenna array at the top of communication device 200 and a second antenna array at the bottom of communication device 200. In some aspects, antenna system 202 may additionally include analog antenna combination and/or beamforming circuitry. In the receive (RX) path, RF transceiver 204 may receive analog radio frequency signals from antenna system 202 and perform analog and digital RF front-end processing on the analog radio frequency signals to produce digital baseband samples (e.g., In-Phase/Quadrature (IQ) samples) to provide to baseband modem 206. RF transceiver 204 may include analog and digital reception components including amplifiers (e.g., Low Noise Amplifiers (LNAs)), filters, RF demodulators (e.g., RF IQ demodulators)), and analog-to-digital converters (ADCs), which RF transceiver 204 may utilize to convert the received radio frequency signals to digital baseband samples. In the transmit (TX) path, RF transceiver 204 may receive digital baseband samples from baseband modem 206 and perform analog and digital RF front-end processing on the digital baseband samples to produce analog radio frequency signals to provide to antenna system 202 for wireless transmission. RF transceiver 204 may thus include analog and digital transmission components including amplifiers (e.g., Power Amplifiers (PAs), filters, RF modulators (e.g., RF IQ modulators), and digital-to-analog converters (DACs), which RF transceiver 204 may utilize to mix the digital baseband samples received from baseband modem 206 and produce the analog radio frequency signals for wireless transmission by antenna system 202. In some aspects baseband modem 206 may control the radio transmission and reception of RF transceiver 204, including specifying the transmit and receive radio frequencies for operation of RF transceiver 204. In some examples, the ADCs may be or may include an ADC circuit as described herein.

In some examples, communication device 200 may include a communication circuit. Communication device 200 may transmit and receive communication signals with the communication circuit. The communication circuit may be couplable to specified communication interfaces (e.g. E2, A1, O1, etc.). In some aspects, such communication interfaces may be implemented by wireless or wired connections (e.g. backhaul, etc.). In particular, the communication circuit may transmit and receive communication signals to/from network access nodes 110, 120, or an intermediate entity within the radio communication network 100 that may communicate with network access nodes 110, 120. The communication circuit may include RF transceiver 204, and in such an example, the RF transceiver 204 may be configured to transmit and receive communication signals via the respective communication interface.

As shown in FIG. 2, baseband modem 206 may include digital signal processor 208, which may perform physical layer (PHY, Layer 1) transmission and reception processing to, in the transmit path, prepare outgoing transmit data provided by protocol controller 210 for transmission via RF transceiver 204, and, in the receive path, prepare incoming received data provided by RF transceiver 204 for processing by protocol controller 210. Digital signal processor 208 may be configured to perform one or more of error detection, forward error correction encoding/decoding, channel coding and interleaving, channel modulation/demodulation, physical channel mapping, radio measurement and search, frequency and time synchronization, antenna diversity processing, power control and weighting, rate matching/de-matching, retransmission processing, interference cancelation, and any other physical layer processing functions. Digital signal processor 208 may be structurally realized as hardware components (e.g., as one or more digitally-configured hardware circuits or FPGAs), software-defined components (e.g., one or more processors configured to execute program code defining arithmetic, control, and I/O instructions (e.g., software and/or firmware) stored in a non-transitory computer-readable storage medium), or as a combination of hardware and software components. In some aspects, digital signal processor 208 may include one or more processors configured to retrieve and execute program code that defines control and processing logic for physical layer processing operations. In some aspects, digital signal processor 208 may execute processing functions with software via the execution of executable instructions. In some aspects, digital signal processor 208 may include one or more dedicated hardware circuits (e.g., ASICs, FPGAs, and other hardware) that are digitally configured to specific execute processing functions, where the one or more processors of digital signal processor 208 may offload certain processing tasks to these dedicated hardware circuits, which are known as hardware accelerators.

Communication device 200 may be configured to operate according to one or more radio communication technologies. Digital signal processor 208 may be responsible for lower-layer processing functions (e.g., Layer 1/PHY) of the radio communication technologies, while protocol controller 210 may be responsible for upper-layer protocol stack functions (e.g., Data Link Layer/Layer 2 and/or Network Layer/Layer 3). Protocol controller 210 may thus be responsible for controlling the radio communication components of communication device 200 (antenna system 202, RF transceiver 204, and digital signal processor 208) in accordance with the communication protocols of each supported radio communication technology, and accordingly may represent the Access Stratum and Non-Access Stratum (NAS) (also encompassing Layer 2 and Layer 3) of each supported radio communication technology. Protocol controller 210 may be structurally embodied as a protocol processor configured to execute protocol stack software (retrieved from a controller memory) and subsequently control the radio communication components of communication device 200 to transmit and receive communication signals in accordance with the corresponding protocol stack control logic defined in the protocol software. Protocol controller 210 may include one or more processors configured to retrieve and execute program code that defines the upper-layer protocol stack logic for one or more radio communication technologies, which can include Data Link Layer/Layer 2 and Network Layer/Layer 3 functions. Protocol controller 210 may be configured to perform both user-plane and control-plane functions to facilitate the transfer of application layer data to and from radio communication device 200 according to the specific protocols of the supported radio communication technology. User-plane functions can include header compression and encapsulation, security, error checking and correction, channel multiplexing, scheduling and priority, while control-plane functions may include setup and maintenance of radio bearers. The program code retrieved and executed by protocol controller 210 may include executable instructions that define the logic of such functions.

Communication device 200 may also include application processor 212 and memory 214. Application processor 212 may be a CPU, and may be configured to handle the layers above the protocol stack, including the transport and application layers. Application processor 212 may be configured to execute various applications and/or programs of communication device 200 at an application layer of communication device 200, such as an operating system (OS), a user interface (UI) for supporting user interaction with communication device 200, and/or various user applications. The application processor may interface with baseband modem 206 and act as a source (in the transmit path) and a sink (in the receive path) for user data, such as voice data, audio/video/image data, messaging data, application data, basic Internet/web access data, etc. In the transmit path, protocol controller 210 may therefore receive and process outgoing data provided by application processor 212 according to the layer-specific functions of the protocol stack, and provide the resulting data to digital signal processor 208. Digital signal processor 208 may then perform physical layer processing on the received data to produce digital baseband samples, which digital signal processor may provide to RF transceiver 204. RF transceiver 204 may then process the digital baseband samples to convert the digital baseband samples to analog RF signals, which RF transceiver 204 may wirelessly transmit via antenna system 202. In the receive path, RF transceiver 204 may receive analog RF signals from antenna system 202 and process the analog RF signals to obtain digital baseband samples. RF transceiver 204 may provide the digital baseband samples to digital signal processor 208, which may perform physical layer processing on the digital baseband samples. Digital signal processor 208 may then provide the resulting data to protocol controller 210, which may process the resulting data according to the layer-specific functions of the protocol stack and provide the resulting incoming data to application processor 212. Application processor 212 may then handle the incoming data at the application layer, which can include execution of one or more application programs with the data and/or presentation of the data to a user via a user interface.

Memory 214 may embody a memory component of communication device 200, such as a hard drive or another such permanent memory device. Although not explicitly depicted in FIG. 2, the various other components of communication device 200 shown in FIG. 2 may additionally each include integrated permanent and non-permanent memory components, such as for storing software program code, buffering data, etc.

Application processor 212 may be configured to implement various operations provided herein, in particular with respect to the implementation of one or more AI/MLs that are used for RRM of multiple cells associated with multiple network access nodes (e.g. network access node 110, 120) serving to multiple terminal devices (e.g. terminal devices 102, 104). In some examples, application processor 212 may control an external processor that is configured to implement the one or more AI/MLs. In some aspects, the external processor may be particularly suitable for implementing AI/MLs, such as GPUs, neuromorphic chips or circuits, parallel processors, etc.

In accordance with some radio communication networks, terminal devices 102 and 104 may execute mobility procedures to connect to, disconnect from, and switch between available network access nodes of the radio access network of radio communication network 100. As each network access node of radio communication network 100 may have a specific coverage area, terminal devices 102 and 104 may be configured to select and re-select \ available network access nodes in order to maintain a strong radio access connection with the radio access network of radio communication network 100. For example, communication device 200 may establish a radio access connection with network access node 110 while terminal device 104 may establish a radio access connection with network access node 112. In the event that the current radio access connection degrades, terminal devices 102 or 104 may seek a new radio access connection with another network access node of radio communication network 100; for example, terminal device 104 may move from the coverage area of network access node 112 into the coverage area of network access node 110. As a result, the radio access connection with network access node 112 may degrade, which terminal device 104 may detect via radio measurements such as signal strength or signal quality measurements of network access node 112. Depending on the mobility procedures defined in the appropriate network protocols for radio communication network 100, terminal device 104 may seek a new radio access connection (which may be, for example, triggered at terminal device 104 or by the radio access network), such as by performing radio measurements on neighboring network access nodes to determine whether any neighboring network access nodes can provide a suitable radio access connection. As terminal device 104 may have moved into the coverage area of network access node 110, terminal device 104 may identify network access node 110 (which may be selected by terminal device 104 or selected by the radio access network) and transfer to a new radio access connection with network access node 110. Such mobility procedures, including radio measurements, cell selection/reselection, and handover are established in the various network protocols and may be employed by terminal devices and the radio access network in order to maintain strong radio access connections between each terminal device and the radio access network across any number of different radio access network scenarios.

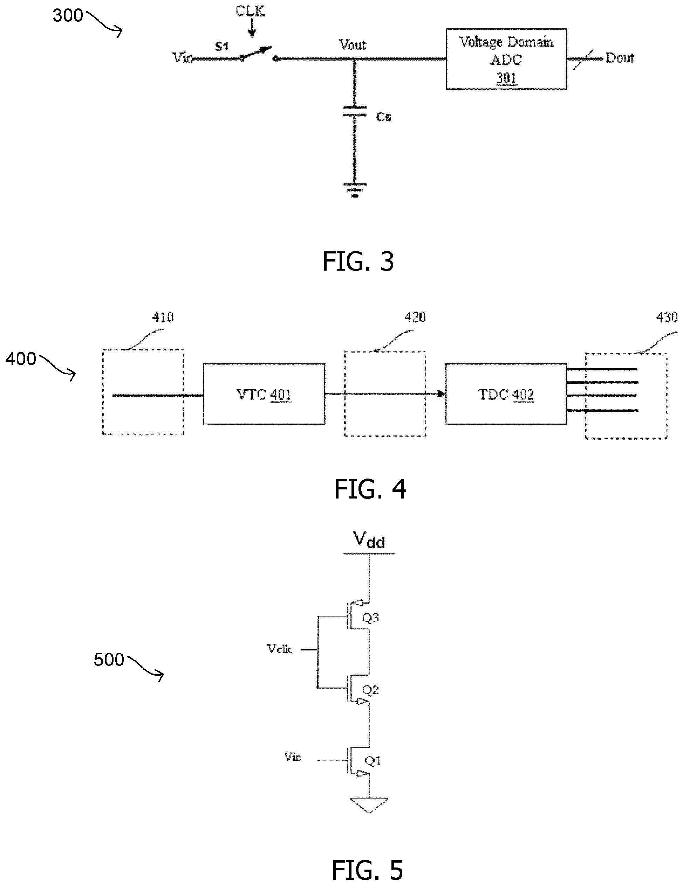

ADCs may be required to support operating at very high sampling rates (>10 GS/s) in modern high-speed communication systems. However, as the sampling rates desired for sampling of analog signals increase, extending the analog input bandwidth of the ADCs may become challenging in traditional ADC architectures that may involve sampling through capacitors, which may be illustrated in accordance with FIG. 3.

Illustratively, in the sampling phase of the ADC, the input analog signal may be sampled to a capacitor that is desired to be large enough to keep the thermal noise (kT/C) sufficiently low, which is inversely proportional to the sampling capacitance. Achieving an acceptable signal-to-noise ratio (SNR) with this approach may require use of larger capacitors which may introduce issues with their form factors in modern communication devices and reduce the ADC bandwidth. Furthermore, to maintain the acceptable SNR, the signal swing of the input analog signal may be desired to be sufficiently large compared to the noise, which may be problematic at high frequencies due to the frequency-dependent attenuation and limited bandwidth at the input network driving the ADC.

Due to above-mentioned challenges, power-hungry input buffer amplifiers may be required for high-speed ADCs, to drive the relatively large sampling capacitance with sufficient bandwidth and signal swing, which may become problematic in modern deep sub-micron CMOS processes. With transistors getting smaller and supply voltages decreasing, communication circuits may generally operate with less voltage headroom. The reduction in voltage headroom may result in increased signal-dependent on-resistance of the sampling switch, which may degrade linearity and may further limit the bandwidth achievable with the operation.

Furthermore, receiver systems (e.g. the communication device 200) may require filtering applications before feeding an input analog signal to the ADC in order to attenuate and/or suppress undesired signals. Such undesired signals may refer to or include noise and/or blockers with certain frequencies that would fall into the Nyquist bandwidth of the ADC. The Nyquist bandwidth of the ADC may refer to a maximum frequency range of the input analog signal that the ADC converts into digital domain without aliasing. Illustratively, $f_s$ may denote the sampling rate of the ADC, and the Nyquist bandwidth of the ADC may be formulated as $f_s/2$.

In addition to anti-alias filtering to reject out-of-band noise and/or blockers, peaking may be desired in some ultra-high-speed applications to enhance bandwidth. Because such filtering must be performed prior to ADC quantization, it typically occurs in the analog domain and requires static power consumption with an active amplifier that must also provide sufficient gain in the system to support the full-scale range of the ADC. This analog-domain filter may also be difficult to reconfigure to support a broad range of bandwidths. While blocker filtering may be applied digitally (e.g. in direct radio frequency sampling systems), it is likely to require oversampling the ADC and burning additional power in the converter.

Various aspects disclosed herein may relate to an ADC circuit. In some aspects, the ADC circuit may include a voltage-to-time converter in order to provide buffering and amplification for high-speed signal sampling. In accordance with various aspects of the disclosure, performance of the ADC circuit may not be restricted by the thermal noise of a sampling capacitor at high sample rates. In various aspects, the ADC circuit may be extended for other design considerations, such as time-interleaved designs.

FIG. 3 shows an ADC circuit 300. The ADC circuit 300 may include a sampling switch S1 and a capacitor Cs. In a sense, the ADC circuit 300 may refer to a conventional approach for sampling an analog signal (i.e. a voltage domain signal) Vin that may change over time and be converted into the digital domain. The sampling switch S1 may be opened and closed based on a clock CLK signal. When the sampling switch S1 is closed at $t_0$, the capacitor Cs may be charged to an instantaneous value of Vin (i.e. Vin at $t_0$) associated with the instantaneous voltage value of the analog signal. The voltage stored in Cs may refer to a voltage domain sample Vout. The voltage domain sample Vout may be an input to the ADC 301 that converts the voltage domain sample Vout into the digital domain.

ADC circuit 300 may capture a voltage domain signal at a time interval equivalent to the inverse of the sampling rate of the ADC 301. For example, the sampling rate of the ADC 301 may be denoted as $f_s$, and the time interval at which the voltage domain signal Vin is captured may be denoted as $1/f_s$. However, signal-to-noise ratio (SNR) achieved using such a sampling scheme may be limited by the thermal noise sampled on the capacitor Cs with respect to the voltage domain signal Vin. Improving SNR may require employing a higher capacitance than presented with the capacitor Cs or a larger signal swing than presented with the voltage domain signal Vin. However, such approaches may not come without a tradeoff. For example, employing a higher capacitance may reduce bandwidth, and providing a larger signal swing at the input may emerge more strict stringent requirements on the circuit driving the ADC 301.

FIG. 4 shows an ADC circuit 400 in accordance with various aspects described herein. As opposed to conventional ADC circuit 300 configured for the conversion operation in voltage domain, the ADC circuit 400 may refer to a time-based ADC circuit. The ADC circuit 400 may include a voltage-to-time converter (VTC) 401 and a time-to-digital converter (TDC) 402. In some examples, an analog signal 410 (e.g. carrying information in the voltage domain, which is to be converted into a digital signal) may be input for the VTC 401. The VTC 401 may convert the voltage domain signal into a time delay (i.e. time difference with a reference signal, such as a reference clock signal (e.g. the input clock signal)). In that sense, the voltage domain signal may be represented as time delays within the time domain, which may refer to a phase-shift or delayed version. The output signal of the VTC 401 may be referred herein as a time-domain output signal 420. The output signal of the VTC 401 representing the voltage domain signal in the time domain may be an input for the TDC 402. TDC 402 may convert the time delays (i.e. time-domain output signal) into digital output signal 430.

Generally, time-based ADC circuits may be more power-efficient compared to voltage-domain ADCs, especially in low-voltage and high-speed scenarios. Furthermore, time-based ADCs may be implemented via digital structures and it may be provide more flexibility for reconfiguration compared to voltage-domain ADCs.

In some aspects, time delays implemented by the VTC 401 may be based on input clock pulses. In some cases, the VTC 401 may determine a respective delay of the time delays at each designated transition of the input clock pulses (e.g. at each rising edge or at each falling edge of the input clock signal, or both as described herein). In such cases, the VTC 401 may include or may be a pulse position modulator. In some examples, delay may be applied to both edges (i.e. rising and falling edges) of the input clock pulses. In such examples, the VTC 401 may refer to pulse width modulator. In comparison with the conventional ADC circuit scheme shown in FIG. 3, the time-based ADC circuit may operate at high clock frequencies as well as consume less power and decrease die overhead.

In order to generate time delays in accordance with the instantaneous voltage level of the input voltage domain signal, VTC 401 may include a voltage-controlled delay circuit (VCDC) as described herein. In some aspects, the VCDC may include one or more voltage-controlled delay cells. In some examples, a voltage-controlled delay cell may be implemented with current-starved inverters. In such an example, the delay that is proportional to an instantaneous voltage level of the input voltage domain signal may be provided by one or more current-starved inverters.

FIG. 5 shows an example of a current-starved inverter 500. The current starved inverter 500 may include an inverter including transistors Q2 and Q3 in which the source of the transistor Q3 is connected to a voltage source Vdd. In some aspects, transistor Q2 may be a complementary type of transistor Q3, or vice versa (e.g. NMOS and PMOS as illustrated). Accordingly, transistor Q2 may be an N-type transistor and transistor Q3 may be a P-type transistor. For the current-starved inverter 500, an input voltage Vin provided to the gate of Q1 may control the delay (e.g. at falling edge of an input clock signal Vclk) through the inverter (i.e. transistor Q2 and transistor Q3). Such control may be achieved by the input voltage Vin as Vin may control the discharging current of transistor Q1.

In some aspects, ADCs may require a plurality of parallel channels to form a time-interleaved ADC. In such a constellation, each parallel channel of the time-interleaved ADC may generate a respective sample of an input analog signal in an alternating manner. In this way, the respective sampling rate of each channel may be relaxed to a point proportional to the number of parallel channels. Once samples generated at each channel are merged within the digital domain, the overall sampling frequency of the time-interleaved ADC may be achieved. For example, a sampling operation using a time-interleaved ADC having K channels may be equivalent to a sampling operation using an ADC with a sampling rate that is K times higher in comparison with the sampling rate obtained at each channel.

Referring back to FIG. 4, VTC 401 may generate the time domain output signal based on samples of the input analog signal taken at both rising edge and falling edge of the input clock signal, which may increase the power efficiency compared to traditional methods. In such a case, the amount of the respective delay introduced for a rising edge or for a falling edge of the input clock signal may be based on the respective sample of the input analog signal. In some examples, VTC 401 may provide a differential delay output instead of single-ended start/stop pulses. For example, VTC 401 may include another inverter (e.g. a second inverter) to realize a further time delay such that the time delays on both rising and falling edges of the input clock signal may be differentiated. In some aspects, VTC 401 may employ a single delay stage. In a sense, the single delay stage may bring about advantages in terms of minimizing integration time and boosting ADC bandwidth when compared to voltage-to-frequency conversion.

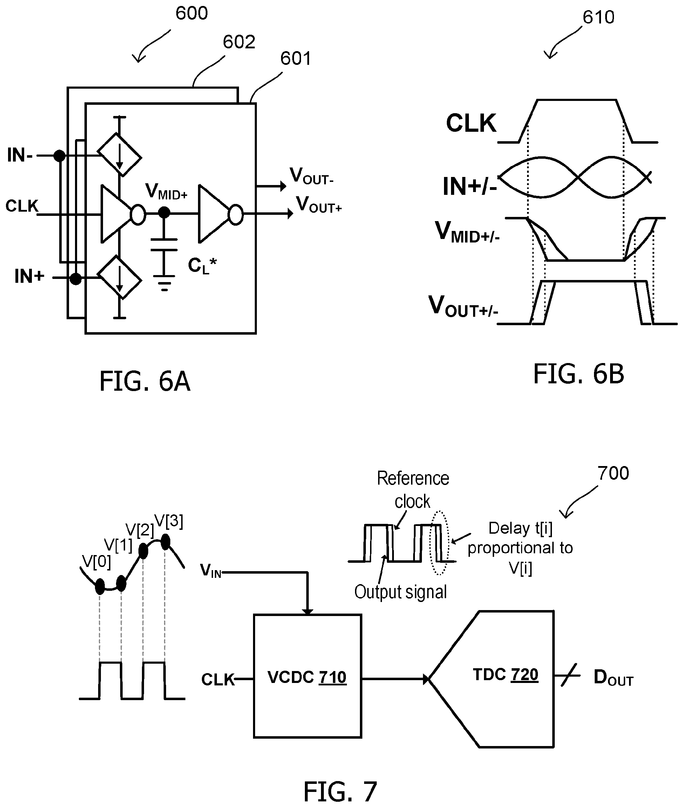

FIG. 6A shows an example of voltage-controlled delay circuit 600 in accordance with various aspects described herein. The VCDC 600 may include a current-starved inverter 601. In a current-starved inverter implementation of the VCDC 600, the VCDC 600 may include a current limiter including current limiting components configured to control the current of the inverter based on the input analog signal, which the current limiting components may refer to or include a current source and/or a current sink respectively for each transistor of the inverter. Illustratively, the current limiting components may control the current flowing into the inverter in a manner that is responsive to the input analog signal, which correspondingly changes the propagation delay of the inverter with respect to the input clock signal to generate the output signal. In other words, the current source and the current sink, which are responsive to the input analog signal IN+, may control the current of the inverter that inverts the input clock signal with a delay that is based on the controlled current.

In some aspects, for a single-ended operation, the VCDC 600 may include a single current-starved inverter (e.g. current-starved inverter 601) as depicted herein. In some examples, the VCDC 600 may include the current sink configured to change the current of the inverter based on a further input analog signal IN- (e.g. voltage domain signal). In some aspects, the further input analog signal IN- may be inverse of the analog signal IN+. Therefore, the current source and the current sink may limit the current of the inverter based on input analog signals IN-/+. The inverter may receive an input clock signal CLK and may generate an output signal that is representative of a time shifted version of the input clock signal with a delay in time domain that is based on the input analog signal. The VCDC 600 may be used to implement delay cells of a VCDC included in a VTC (e.g. VTC 401).

It is to be recognized that the VCDC 600 illustrated herein includes two current starved inverters, namely a first current starved inverter 601 as described above, and a second current starved inverter 602. The second current starved inverter 602 may have the same schematic as illustrated for the first current starved inverter 601 with certain differences mentioned below with respect to input and output signals. In other words, the VCDC 600 may include at least two current starved inverters in a differential configuration such that, in addition to aspects described above for the current-starved inverter 601 that is the first current-starved inverter 601 of the differential configuration, the VCDC 600 may include a second current-starved inverter 602. The second current-starved inverter 602 may include a further current limiting components (i.e. a second current source and a second current sink), and a second inverter. The second inverter may generate a second output signal based on the input clock signal. Similarly, the second current source and the second current sink may control the current of the second inverter based on input analog signals IN-/+. In such a case, as opposed to the scheme described for single-ended (i.e. non-differential) delay output, the second current source may control the current of the second inverter based on the input analog signal IN-. Accordingly, the second current sink may control the current of the second inverter based on the input analog signal IN+.

In some aspects, the current source and the current sink may control the charging and discharging current of the parasitic capacitor $C_L^*$ of the VCDC 600 for single-ended delay (e.g. non-differential) output implementations. In that sense, $C_L^*$ may denote a parasitic capacitance only. Additionally, or alternatively, the current source and the current sink may control the charging and discharging current of the parasitic capacitor $C_L$ of the first and second inverter for differential delay output implementations.

In some aspects, the current sources and the current sinks of the VCDC 600 may control the current of the inverter based on the input analog signal (IN+) and the complementary input analog signal (IN-) in order to modulate voltage-to-time gain. Illustratively, the current of the inverter may be further controlled, in addition to the input analog signal (IN+) and the complementary input analog signal (IN-), with a further control voltage applied to control the current source and the current sink to modulate the voltage-to-time gain. In some aspects, voltage-to-time gain may refer to adjusting the gain of the VCDC 600 over time.

FIG. 6B depicts a timing diagram 610 in accordance with the VCDC 600 including current-starved inverters in a differential configuration. The timing diagram shows two output signals, as output signals of the differential current starved inverters, Vout+ and Vout-. In that sense, the time delay may refer to a modulated (e.g. phase-shifted) clock signal of the input clock signal CLK in which the amount of delay applied on an edge, which may be both a respective rising edge or a respective falling edge, is controlled and/or determined by an instantaneous level of the input analog signal (i.e. analog signal sample). A differential time delay between the transition edges of Vout+ and Vout- may represent the differential voltage between IN+ and IN-during the input clock signal CLK transition. Time delay, as depicted, may refer to a delay applied (i.e. applied by the interver) on both the rising and the falling edges of the clock pulses of input clock signal CLK. This may refer to a scheme in which the input analog signal may be sampled on each rising and falling edge of the clock pulses of input clock signal CLK.

The timing diagram 610 in accordance with the operation of current-starved inverter 600 may further reveal a timing diagram of voltage levels of intermediate terminal $V_{MID+/-}$ coupled to the parasitic capacitor $C_L$, a timing diagram of voltage levels of the input analog signal IN+/-, and the input clock signal CLK.

FIG. 7 shows a time-based ADC circuit 700 for analog signal sampling, in accordance with various aspects described herein. In some aspects, time-based ADC circuit 400 depicted in FIG. 4 may be implemented as the time-based ADC circuit 700. The time-based ADC circuit 700 operation may include an input analog signal varying over time, illustratively instantaneous voltage level of the input analog signal may have different voltage levels at different time instances. The time-based ADC circuit 700 may include an input terminal to receive the input analog signal. For example, the input analog signal $V_{IN}$ may be a voltage domain signal having a voltage level V[0] at a first time $t_0$, voltage level V[1] at a second time $t_1$, voltage level V[2] at a third time time $t_2$, and the like. In some aspects, V[0] may refer to a different voltage level than V[1], although it may be possible for some instances that V[0] may represent an equal voltage level in comparison with V[1]. The comparison between V[0] and V[1] may be non-limiting and extended to any instantaneous voltage level associated with the input analog signal $V_{IN}$ (e.g. V[2], V[3],...).

In accordance with various aspects disclosed herein, the time-based ADC circuit 700 may perform signal sampling based on an input clock signal (e.g. clock pulse) CLK. In some cases, voltage levels V[0], V[1],... may refer to instantaneous voltage levels, which may be referred to herein as analog signal samples, of the input analog signal $V_{IN}$ at the rising and/or falling edge of the clock pulse. In an example, V[0] and V[2] may refer to instantaneous voltage levels of the input analog signal $V_{IN}$ at the rising edge of the clock pulse, while V[1] and V[3] may refer to instantaneous voltage levels of the input analog signal $V_{IN}$ at the falling edge of the clock pulse. In some examples, input clock signal CLK and $V_{IN}$ may be inputs received at input terminals of a VTC (e.g. VTC 201) and $V_{IN}$ may be sampled at each rising or falling edge of the input clock signal CLK. In some cases, ADC circuit 700 may sample $V_{IN}$ at each both rising and falling edge of the input clock signal CLK. The VTC may include a VCDC 710 to generate time delays based on the input clock signal CLK at the output of the VTC. In accordance with various aspects of the disclosure, the VCDC 710 of the ADC circuit 700 may include one or more current-starved inverters (e.g. a current-starved inverter 400) for sampling the input analog signal $V_{IN}$ at each rising or falling edge of the input clock signal CLK in order to generate at least some of the analog signal samples (e.g. V[0], V[1], V[2], V[3]). In some examples, the ADC circuit 700 may include a VCDC (e.g. the VCDC 600) for sampling the input analog signal at both each rising edge and each falling edge of the input clock signal CLK.

VCDC 710 may generate an output signal representing time delays at a time domain output terminal. That is, VCDC 710 may generate an output signal with an amount of delay introduced at each rising and falling edge of the input clock signal, in which the amount of delay t[i] is based on the input analog signal. Therefore, the output signal may represent a signal shifted in time domain with a delay in comparison with the input clock signal CLK. In some aspects, amount of delay t[i] introduced to each rising and falling edge of the clock pulse of reference clock in order to obtain the time domain output signal may be based on instantaneous voltage levels V[i] of the input analog signal $V_{IN}$. For example, a first time point (e.g. $t_0$) may be associated with a rising edge of the first clock pulse and input analog signal $V_{IN}$ may be sampled at voltage level V[0], a second time point (e.g. $t_1$) may be associated with a falling edge of the first clock pulse and input analog signal $V_{IN}$ may be sampled at voltage level V[1]. VCDC 710 may apply an amount of delay to the rising edge of the first clock pulse proportional to voltage level V[0]. Similarly, VCDC may apply an amount of delay to the falling edge of the first clock pulse proportional to voltage level V[1].

ADC circuit 700 may include a time-to-digital converter (e.g. TDC 402) in order to convert the time domain output signal into the digital domain. In some examples, TDC 720 of the ADC circuit 700 may receive the time domain output signal representing time delays associated with analog signal samples at a digital input terminal. TDC 720 may convert the time domain output signal into the digital domain. Therefore, TDC 720 may perform quantization on the time domain output signal and generate a digital output at a digital output terminal based on the time domain output signal.

In accordance with various aspects disclosed herein, a VTC may include a transistor-based VCDC to optimize bias voltage for linearity and gain control. In some examples, the VCDC may include a current starved delay element that may be implemented using a variety of transistor-level implementations to provide a delay element. As denoted, such delay elements/delay cells may be essential to apply a time shift to a rising and/or falling edge of a clock pulse based on an input clock signal. Therefore, such delay elements may be considered as a fundamental block of the VCDC 710, and accordingly, VTC.

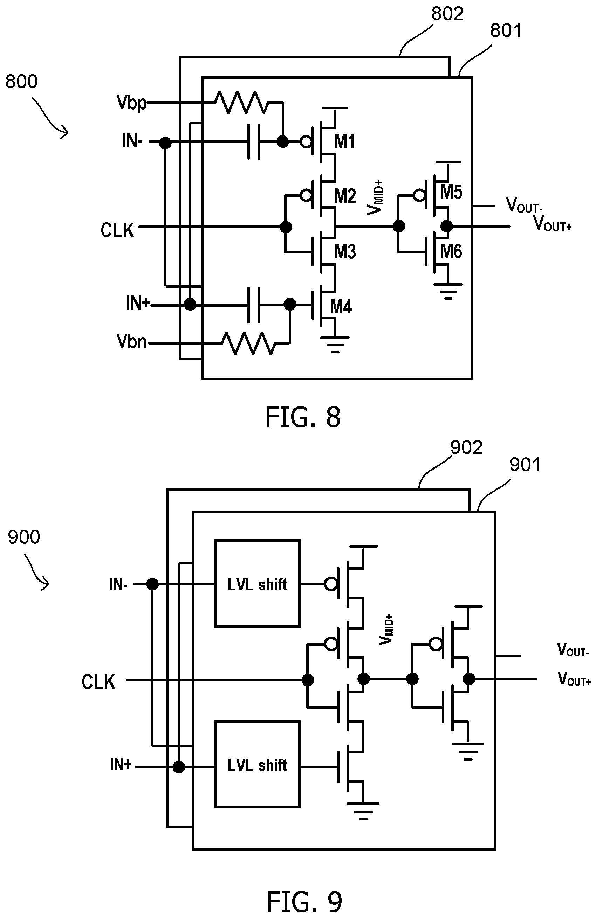

FIG. 8 depicts a first example of a transistor-level implementation 800 of a VCDC (e.g. VCDC 600, VCDC 710) in accordance with various aspects of the disclosure. The first example of a transistor-level implementation may be used in the VCDC for instance to optimize bias voltage for linearity and gain control. In some examples, the VCDC may include only the first cell 801 described herein for single-ended operation. In some examples, the VCDC may include two identical cells of current starved inverters 801 and 802, connected in a differential configuration as described herein. Aspects described herein for the first cell 801, apply to the second cell 802 as well except the differences associated with the differential configuration described herein.

In the first cell 801, transistor M1 coupled to a voltage source Vdd and transistor M4 coupled to the ground may be the current limiting components responsive to the input analog signal received at their gates. Transistors M2 and M3 may form an inverter that receives an input clock signal CLK. In this illustrative example, the gates of transistors M1 and M4 may further be connected to respective control terminals $V_{BP}$ and $V_{BN}$ to receive a control voltage applied to modulate voltage-to-time gain of the VCDC. In some cases, an intermediate node $V_{MID+}$ may receive an output of the inverting circuit which may be modulated and inverted at the circuit including transistors M5 and M6. Therefore, the VCDC may generate a time domain output at the time domain output terminal Vout.

In a differential configuration, the VCDC may include the second cell 802 with the first cell 801. The second cell 802 may operate similarly to the first cell 801 with the difference that transistor M1 of the second cell 802 receives the input signal of transistor M4 of the first cell 801 (i.e. IN+) and transistor M4 of the second cell 802 receives the input signal of transistor M1 of the first cell (i.e. IN-). Correspondingly, the VCDC may generate two time domain output signals Vout+ and Vout- at the outputs of the first cell 801 and the second cell 802 respectively.

FIG. 9 depicts a second example of a transistor-level implementation 900 of VCDC (e.g. the VCDC 600) in accordance with various aspects of the disclosure. In some examples, the VCDC may include only the first cell 901 described herein for single-ended operation. In some examples, the VCDC may include two identical cells of current starved inverters 901 and 902, connected in a differential configuration as described herein. Aspects described herein for the first cell 901, apply to the second cell 902 as well, except the differences associated with the differential configuration described herein.

In comparison to aspects described in FIG. 8, the first cell 901 may include level shifters denoted as LVL shift in FIG. 9. In such a constellation, the level shifters may shift the corresponding input analog signals (i.e. voltage domain signal) IN+ and IN- to cause a voltage shift, which may allow controlled delay introduction. Level shifters may enable a DC level shifting for bias adjustment and may also be used for system-level DC offset control.

In an example, for single-ended implementations, a first level shifter may shift an input analog signal (i.e. voltage domain signal) in order to obtain a first shifted voltage. For example, the first level shifter may shift the input analog voltage IN+. In such a case, the first level shifter may refer to a level shifter driving an NMOS gate in the VCDC. Accordingly, a second level shifter may shift a complementary input analog signal (i.e. voltage domain signal) representing the inverse of the input analog signal in order to obtain a second shifted voltage. For example, the second level shifter may shift the complementary input analog voltage IN-. In such a case, the second level shifter may refer to a level shifter driving a PMOS gate in the VCDC.

In some aspects, in addition to the first cell 901, a second cell 902 may be used to realize differential output implementation as opposed to the single-ended implementation. The second cell 902 may include the identical current-starved inverter with level shifters as described for the first cell 901. In such cases, number of level shifters required may be doubled. For example, there may be a level shifter driving a NMOS gate in the VCDC to shift input analog signal IN+ associated with the first cell 901, a level shifter driving a NMOS gate in the VCDC to shift complementary input analog signal IN- associated with the second cell 902, a level shifter driving a PMOS gate in the VCDC to shift complementary input analog signal IN- associated with the first cell 901, a level shifter driving a PMOS gate in the VCDC to shift input analog signal IN+ associated with the second cell 902. Such requirements may result from two cells (e.g. current-starved inverters) being in a differential configuration. As denoted for other implementations of the cell, VCDC (e.g. cell/inverter) may generate a time domain output signal at the time domain output terminal.

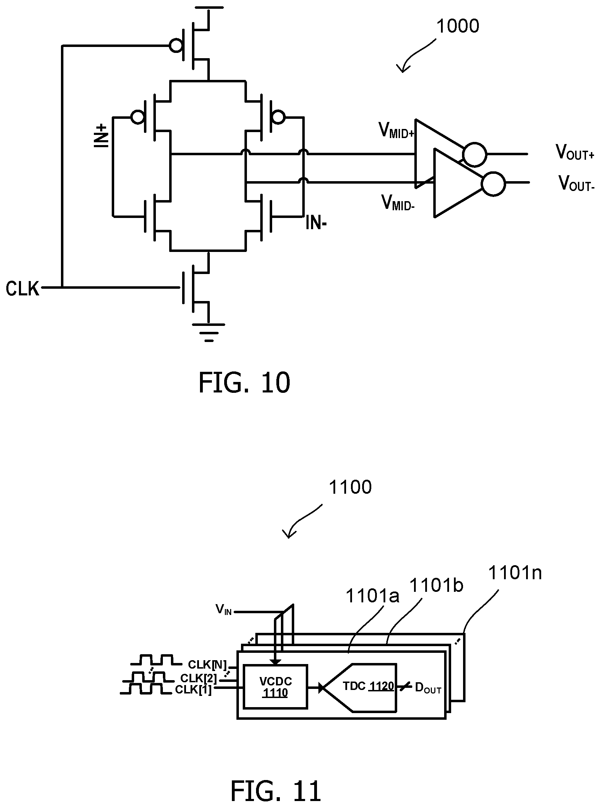

FIG. 10 depicts a third example of a transistor-level implementation 1000 of VCDC (e.g. the VCDC 600, the VCDC 710) in accordance with various aspects of the disclosure. In this example, the VCDC may include an inverting amplifier. For example, the VCDC may include an operational amplifier in inverting mode to generate time-domain output signals VOUT+ and VOUT- that are delayed versions of the input clock CLK, with delays proportional to the average input voltage IN+ and IN- at rising and/or falling edges of CLK. The inverting amplifier may have a designated gain that controls the voltage-to-time conversion gain of the VCDC 1000.

In accordance with various aspects disclosed herein, a time-based ADC (e.g. ADC 700) may be extended to time-interleaved ADCs, with multiple phase-shifted clocks applied to parallel instances of the VTC and TDC. While a typical time-interleaved capacitive voltage sampling ADC may require narrow sampling pulses to minimize the number of parallel capacitive loads appearing simultaneously at the switch input, the capacitive load at the input terminal of such ADC may be independent of the clock pulse width. The constant capacitive load may be compatible with passive bandwidth extension techniques such as inductive peaking without requiring a dedicated buffer. As such an ADC may utilize voltage to current conversion to modulate the delay of the reference clock, it may tolerate a small input analog signal swing that is limited by the input-referred noise of the reference transistor but not the thermal noise of the sampling switch and capacitor in a conventional ADC circuit.

FIG. 11 depicts an example of a time-interleaved ADC 1100. The time-interleaved ADC 1100 may include parallel cells of a time-based ADC (e.g. ADC Circuit 700), each cell operating in its respective instance. With a reference to ADC Circuit 700, the time-interleaved ADC 1100 may include a plurality of ADC circuits described in accordance with FIG 6, in which each ADC circuit may correspond to a respective cell of the plurality of cells including its respective VCDC 1110 and its respective TDC 1120. Each VCDC 1110 may receive a corresponding input clock signal. For example of a time-interleaved ADC with N number of cells 1101a-n, the respective VCDC 1110 of a first cell 1101a may receive a first input clock signal CLK[1], the respective VCDC of a second cell 1101b may receive a second input clock signal CLK[2], and the respective VCDC of a Nth cell 1101n may receive an n-th clock signal CLK[N], etc. Each clock signal received by a respective VCDC may be a phase-shifted version of clock signals received by neighboring VCDCs that are neighbor to the respective VCDC. The VCDCs may further receive a common input analog signal (i.e. voltage domain signal) to generate a time domain output signal based on the corresponding input clock signal at their respective time domain output terminal. In some examples, each TDC 1120 may generate a respective digital output signal based on a delay associated with the time domain output signal. In some cases, such delay may refer to a delay between the time domain output signal and the input clock signal. In some aspects, the delay may refer to a delay between a plurality of time domain output signals (e.g. a first time domain output signal and a second time domain output signal). In some aspects, an oscillator may generate the input clock signal. In some examples, the oscillator may include a phase-locked loop (PLL) or a delay-locked loop (DLL). Each VCDC described herein may be any one of VCDCs described in this disclosure (e.g. VCDC 600, VCDC 710, VCDC 800, VCDC 900, VCDC 1000).

In some aspects, each VCDC 1110 may include a current-starved delay element, such as current-starved inverter 600. In such cases, the current-starved inverter may include a current source and a current sink in order to control the current of the inverter. Therefore each current source and current sink may receive a corresponding input analog signal to regulate the current of the inverter. In some examples, the current sink may receive a positive input analog signal and the current souce may receive a negative input analog signal in which the negative input analog signal may be the inverse of the positive input analog signal.

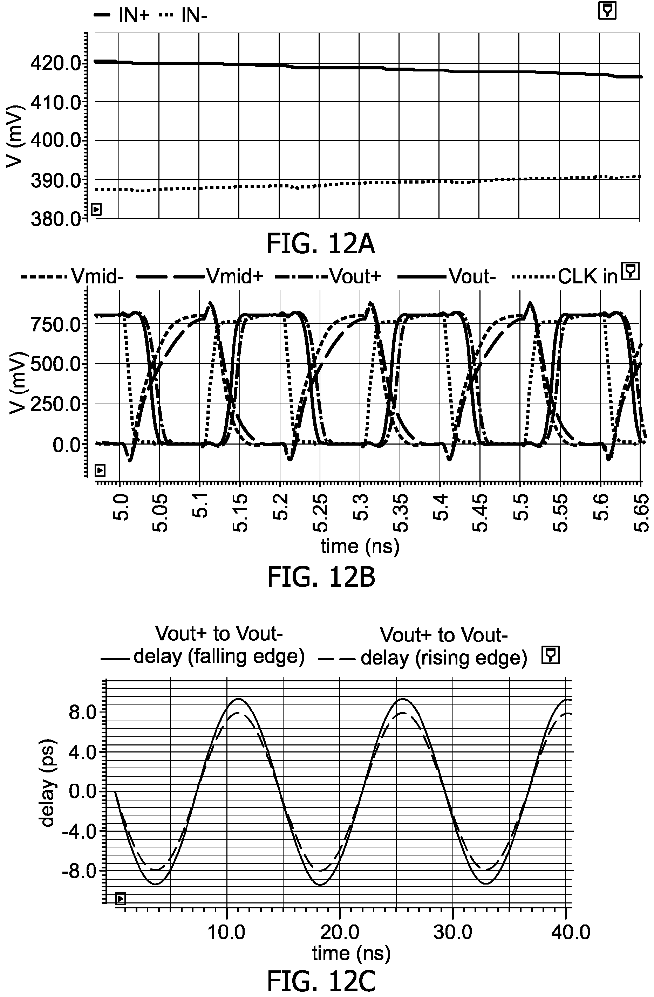

FIG. 12A, 12B and 12C show simulation results in accordance with various aspects of the disclosure. The simulation result may be obtained as a result of a VCDC circuit (e.g. VCDC circuit 710) operation. The ADC circuit may leverage transistor-level implementation described herein (e.g. transistor-level implementation of a current-starved delay element shown in FIG. 8) to realize a voltage-controlled delay element included in a VCDC of the ADC circuit. The voltage-controlled delay element may be a pseudo-differential voltage-controlled delay element modulated on each of both rising and falling edge of a clock pulse of an input clock signal. The ADC circuit may be a fast ADC circuit with an effective sampling rate of 10 GS/s. FIG. 12A depicts simulated time domain waveforms in accordance with an input analog signal IN+ (i.e. voltage domain signal) and complementary input analog signal (i.e. inverted) IN-. FIG. 12B depicts simulated time domain waveforms in accordance with the output signal received at the intermediate node Vmid+/- (e.g. output of inverter circuit), the time domain signal received at the time domain output terminal of the VCDC, Vout+/-, and the input clock signal CLK.

FIG. 12C depicts a differential delay output for rising and falling edges of the clock pulses of the input clock signal CLK. In some aspects, transient noise may artificially be included in the simulation to estimate the performance of ADC in terms of signal-to-noise ratio (SNR). Typical limitation put forward by the thermal noise to SNR in such an ADC circuit with 65 fF sampling capacitance and 40 mV input voltage signal swing may be equivalent to 38dB.

$$SNR = 20 \log_{10} \frac{0.5 \times (40\,mV)^2}{\dfrac{4kT}{2 \times 65\,fF}} = 38.0\,dB$$

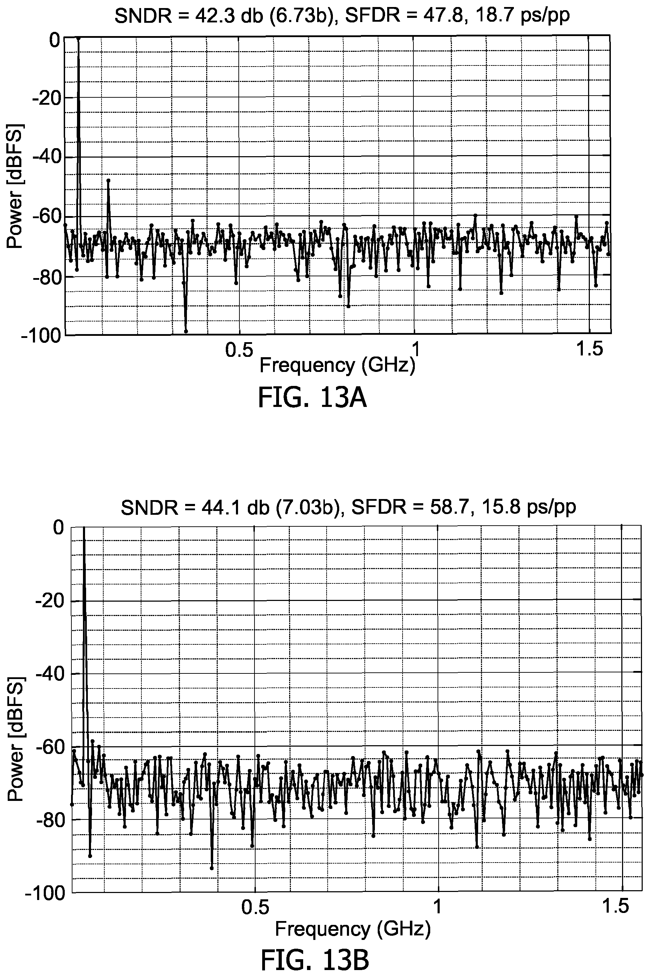

FIG. 13A and 13B depicts frequency response of simulated time domain delay associated with rising and falling edge of the clock pulses of an input clock signal. In particular, FIG. 13A shows a frequency response of simulated time-domain delay for falling edge and FIG. 13B shows a frequency response of simulated time-domain delay for rising edge. In comparison to SNR equation given, the active sampling ADC circuit may achieve an SNR of 44 dB with an equivalent input voltage signal swing and input capacitance.

SNR relative to input capacitance may benefit further from process technology scaling to maximize the device transconductance per gate capacitance. The input capacitance may refer to or include parasitic capacitances of the input transistor. From the perspective of active sampling, such scaling may not be limited by the thermal noise. Unlike the time-dependent load of a typical capacitive sampler, the input transistor may isolate the input analog signal from the switching transients of the output signal. Based on a simulation, this scheme would consume 3.4 mA from a 0.8V supply with an effective ADC sampling rate of 10 GS/s. If such a technique may be implemented in an ADC circuit with a total resolution of 6 effective bits, this translates to a low efficiency overhead of 4.5 fJ/conversion step. The mechanism for ADC bandwidth limitation may also be different from a typical voltage-domain ADC. In a capacitive sampler, the ADC bandwidth may be dictated by the load capacitance, switch resistance, and the strength of the circuit driving the ADC which leads to a second order low pass filter response.

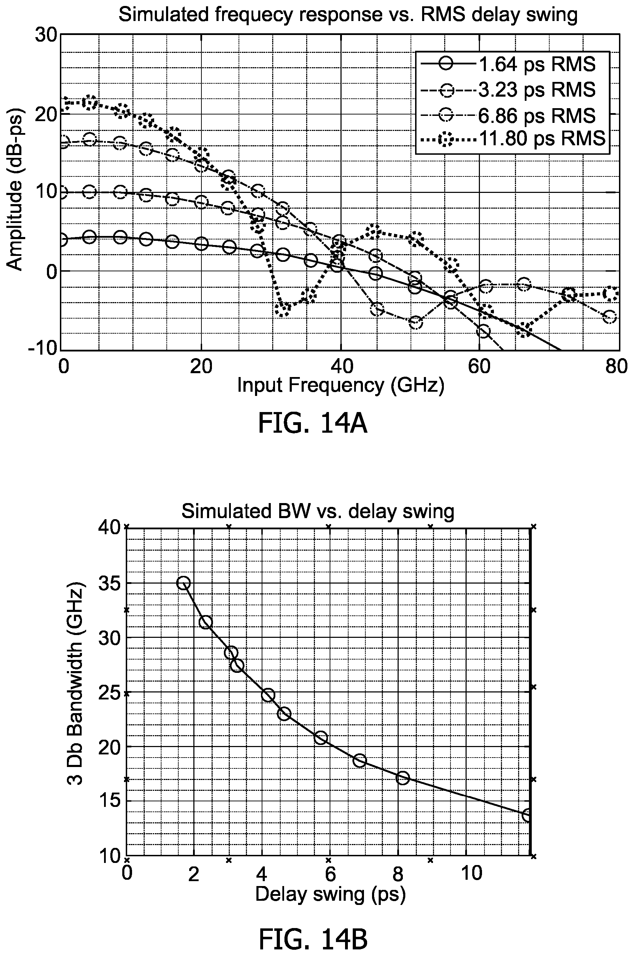

FIG. 14A and FIG. 14B show simulation results in accordance with various aspects of the disclosure. In particular, FIG. 14A depicts a simulation of frequency response of a single-stage sampler and FIG. 14B depicts 3 dB bandwith as a function of delay swing associated with the single-stage sampler. In some aspects, the voltage-controlled current may be integrated during the clock transition as the output waveform goes from one rail to the threshold of the next stage logic gate. The next state logic gate may refer to an inverter (e.g. current starved inverter). Such an approach may prove to be compatible with digital process technologies and low supply voltages, as it only requires rail-to-rail switching. Referring to FIG. 14A, integrating characteristics of the single-stage sampler (e.g. sample-and-hold circuit implemented in a single stage or in a circuit block) may be observed in which the ADC bandwidth is inversely proportional to delay swing and notches set by the integration time exist.

In some aspects, the frequency response of the single-stage sampler may be modified. For example, the single-stage sampler may leverage a transistor-level implementation of a delay element, such as the implementation shown in FIG. 8. Therefore, referring back to FIG. 8, the frequency response may be modified by altering bias voltages $V_{BP}$ and $V_{BN}$ of the input transistors M1 and M4, respectively in order to modify the integration time of the sampler. It may also be possible to modify the frequency response by adjusting the capacitive load at the output of the VCDC.

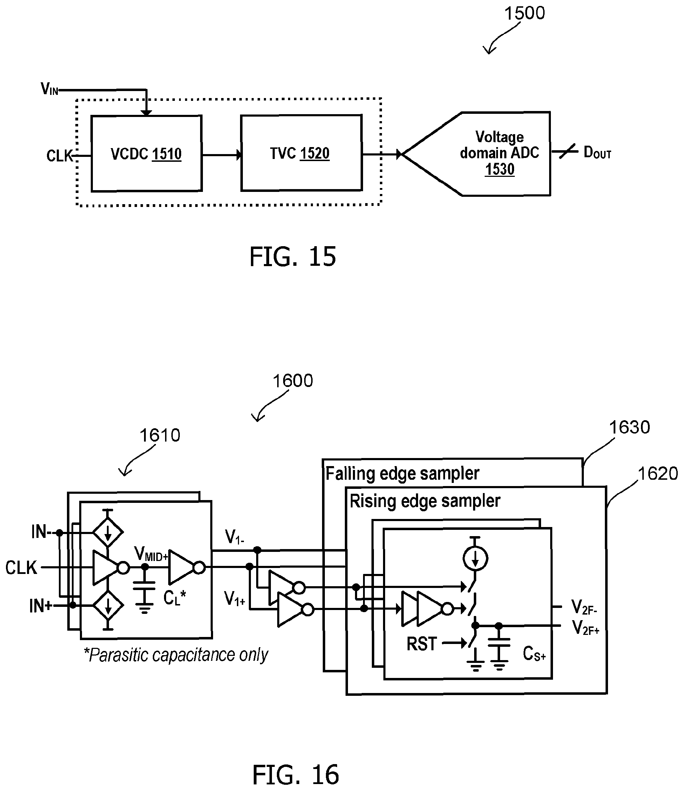

In some aspects, the output time-domain signal of the VCDC may have a relatively small amount of swing when compared to standard cell inverter delays which are often used for time domain quantization. In accordance with various aspects disclosed herein, a time-to-voltage converter (TVC) may be integrated within an ADC circuit in order to convert analog signal samples in time domain (e.g. time domain output signals) back into voltage domain. Such conversion may minimize the impact of jitter and/or noise from subsequent stages depicted in FIG. 15.

FIG. 15 shows an example of ADC circuit 1500. In comparison with a time-based ADC circuit (e.g. ADC circuit 700), the ADC circuit 1500 may employ a TVC 1520 in order to convert time domain signal at the output of VCDC 1510 back into voltage domain. Such time-to-voltage conversion may be performed for each rising and/or falling edge of the time domain output signal since the time domain output signal is based on an input clock signal received by the VCDC 1510, which generates the time domain output signal by applying a delay to the rising and/or falling edge of the clock pulse of the input clock signal CLK. In some aspects, time-to-voltage conversion may be performed for any of both rising and falling edge. In such a case, VCDC 1510 may generate a time domain output signal by applying a delay to either one of rising or falling edge. $V_{IN}$ may denote an input analog signal, with a similar function and characteristics to the ones described for time-based ADC circuit and/or operation within the disclosure. The conversion from time domain to voltage domain may be implemented in part through inverting the time domain signal. ADC circuit may include a voltage domain ADC 1530, which may receive the voltage domain signal converted from time domain by the TVC 1520 at an input terminal to generate a digital domain output.

FIG. 16 shows an example of a hybrid VCDC and TVC implementation 1600 for signal sampling in accordance with various aspects of the disclosure. For example, ADC circuit 1500 may include such an architecture to convert the time domain signal into voltage domain. In some cases, hybrid VCDC and TVC implementation 1600 may differ from the implementation of a typical time-based ADC circuit (e.g. ADC circuit 700) as the typical time-based ADC circuit may receive a time domain signal as an input at an input terminal of a TDC for a time-to-digital conversion such that the time domain signal representing analog signal samples may be represented in digital domain at the output of the TDC. Hybrid VCDC and TVC implementation 1600, on the other hand, may include a VCDC 1610 and TVC 1620.

In some examples, hybrid VCDC and TVC implementation 1600 (e.g. for ADC circuit 1500) may differ from the implementation of a basic ADC circuit (e.g. ADC circuit 300) which may refer to a conventional approach for analog signal sampling. Hybrid VCDC and TVC implementation 1600, on the other hand, may include a VCDC 1610 and TVC 1620. For example, the basic ADC circuit may also include a voltage domain ADC. However, sampled signals may be a direct input to the voltage domain ADC without subject to a further conversion (e.g. into time domain). On the other hand, hybrid VCDC and TVC implementation 1600, may achieve a high bandwidth signal amplification and signal sampling.

In some examples, VCDC 1510 may include a current-starved inverter 1610 (e.g. current-starved inverter 600). The output of VCDC 1510 may refer to a time domain output signal. The VCDC 1510 outputs V1- and V1+ may be used to drive identical TVC samplers 1620 and 1630, with the inputs to TVC 1620 inverted so that TVC 1620 converts the rising edge of the time domain signal and TVC 1630 converts the falling edge of the time domain signal. Therefore, TVC 1520 may include a rising edge sampler 1620 and a falling edge sampler 1630. In some cases in which differential delay output implementation is operated, TVC 1520 may convert time delay between the time domain output signals into voltage domain. Such implementation may integrate a sampling capacitor Cs with a current source for a time period set by the differential time delay between the time domain output signals. Therefore, through the integration process as described, TVC 1520 may generate a voltage sample based on time domain output signals. Additionally, or alternatively, TVC 1520 may be able to sample the time domain output signals in order to perform time-to-voltage conversion.

Although FIG. 16 shows a PMOS current source connected to the positive supply rail (e.g. Vdd) of the circuit in an implementation of TVC 1520, a complementary approach may also be possible in which an NMOS current source discharges the sampling capacitor Cs for a signal-dependent time. In such a case, Cs may be reset to the voltage supply (e.g. Vdd) instead of ground when the reset signal RST closes the reset switch.

In accordance with various aspects disclosed herein, an ADC circuit (e.g. ADC circuit 1500) may include a voltage domain ADC (e.g. voltage domain ADC 1530), as a part of the ADC circuit leveraging hybrid VCDC and TVC implementation. In some aspects, the voltage sampling rate may be faster than a voltage domain ADC can efficiently operate. In such a case time-interleaved approach may be used to realize parallel channels in which each channel of the parallel channels constituting a time-interleaved ADC may have a sampling rate smaller than an aggregated sampling rate. Such an approach may reduce channel speed for power conservation.

In order to implement time-interleaving approach for an ADC circuit leveraging hybrid implementation of VCDC and TVC, a time domain signal may be divided. Such a division may be performed by digitally dividing a time domain output signal. Additionally, or alternatively, division (e.g. by implementation of N-dividers) may also be implemented by combining the time domain signal with divided lower-speed enable signals in the TVC. Using such an approach, a time-interleaved ADC circuit may be achieved in which the ADC circuit may include a hybrid implementation of VCDC and TVC.

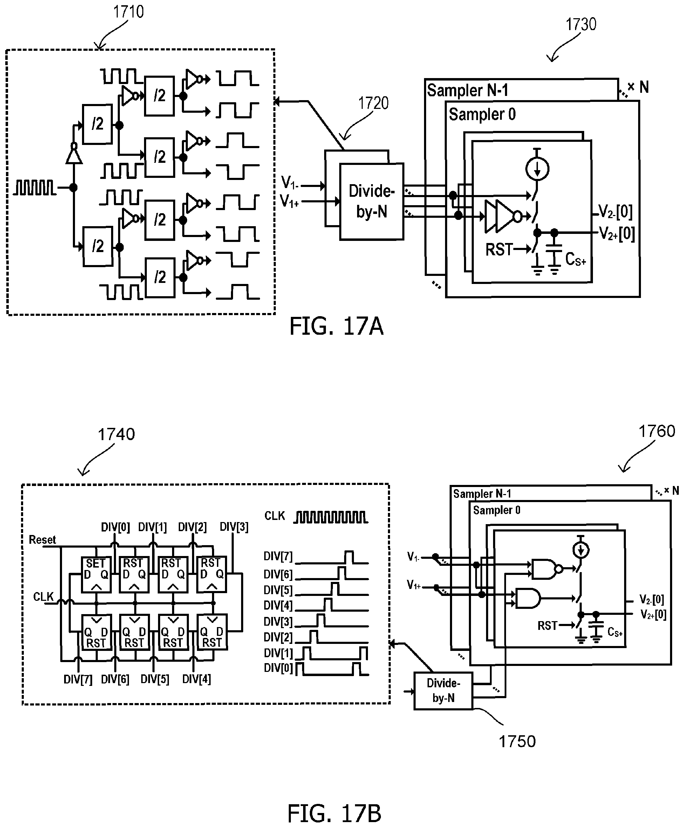

FIG. 17A and FIG. 17B show an example of time-interleaving methodology in accordance with various aspects disclosed herein. In particular, FIG. 17A depicts a time-interleaving technique based on input signal dividers and FIG. 17B depicts a time-interleaving technique based on enable signal dividers.

Referring to FIG. 17A, time-interleaving may be performed by dividing the VCDC output (i.e. time domain output signal) in a direct manner in order to generate TVC inputs. As shown, time domain output signal may be divided by a divide-by-8 architecture 1710. In such a scheme, time domain output signal may initially be subject to two instances of divide-by-two dividers. In some examples, a first divide-by-two divider may directly divide the time domain output signal, while a second divide-by-two divider may divide the inverted time domain output signal. Divided time domain output signal and inverted time domain output signal may further be subject to two instances of subsequent divide-by-two dividers of each of the first and second divide-by-two dividers. An output of each of the subsequent divide-by-two dividers may include an inverter to invert the respective time domain output. In such an approach, divide-by-8 architecture 1710 may be applied to both VCDC outputs V1+ and V1- to generate two sets of multiphase time domain signals. The parallel divide-by-N circuits 1720 (i.e. first and second divide-by-N circuits) may generate time domain inputs for each sampler 1730 of each channel (e.g. each TVC) operating in parallel. In that sense, each of parallel divide-by-N circuits 1720 may refer to a high-level generalization of divide-by-8 architecture 1710, which may be extended to a desired division number (e.g. divide-by-16 architecture, etc.) leveraging the scheme implemented to realize the divide-by-8 architecture 1710. In such a scheme, number of samplers 1730 may be equivalent to N. Each sampler 1730 may employ a rising edge and falling edge sampler. Although the scheme illustrated in Fig. 17A depicts a parallel divide-by-N-circuits signalling a differential configuration (e.g. differential delay output implementation), a skilled person would immediately recognize that the scheme may be orchestrated for single-ended configuration (e.g. single-ended output implementation) by e.g. discarding the inverse input analog voltage V1- and employing only the analog input voltage V1+. This reorchestration may also bring about using a single divide-by-N circuit, instead of parallel divide-by-N circuits.

Referring to FIG. 17B, a digital divider 1740 may generate appropriate enable signals from the input clock signal CLK. Such enable signals may combine with the VCDC output signals (i.e. time domain output signals) in order to drive each sampler. The digital divider 1740 may enable a divide-by-8 divider. In such a case, divider outputs may refer to multiphase time domain outputs in order to generate time domain enable signal inputs for each sampler 1760 of each channel (e.g. each TVC) operating in parallel. In that sense, divide-by-N circuit 1750 may refer to a high-level generalization of divide-by-8 architecture 1740, which may be extended to a desired division number (e.g. divide-by-16 architecture, etc.) leveraging the scheme implemented to realize the divide-by-8 architecture 1740. An AND/NAND or logically equivalent gate may be used to propagate the VCDC outputs V1+ and V1- only when the divide-by-N enable signal is active. In such a scheme, number of samplers 1760 may be equivalent to N. Each sampler 1760 may employ a rising edge and falling edge sampler. Although the scheme illustrated in Fig. 17B may signal the differential configuration (e.g. differential delay output implementation), a skilled person would immediately recognize that the scheme may also be orchestrated for single-ended configuration (e.g. single-ended output implementation) by e.g. discarding the inverse input analog voltage V1- and employing only the analog input voltage V1+ and a single divide-by-N circuit.

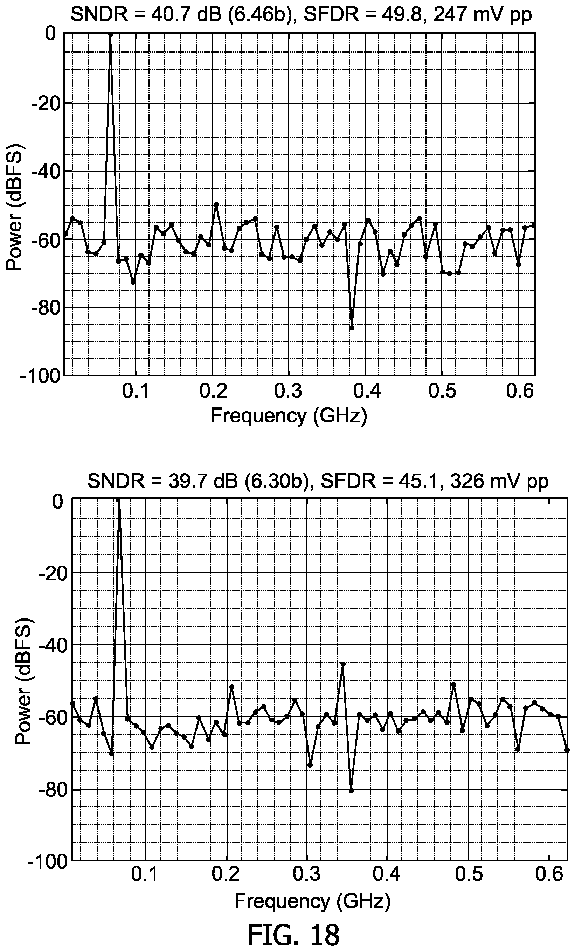

FIG. 18 shows a simulation in accordance with various aspects disclosed herein. In particular, FIG. 18 shows the simulated TVC performance that may be achieved by implementing time-interleaving methodology based on enable signal dividers as shown in FIG. 17B. In implementation, a divide-by-4 enable circuit may drive a total of eight TVCs with 80fF sampling capacitance on each side. A VCDC (e.g. VCDC 501) may be used with an 80mVpp differential input, which may end up having a performance simulated in FIGs. 12A, 12B and 12C. Time-interleaving may cause each channel to operate at 1.25GS/s. In such constellation, the 10GS/s VTC, divide-by-4 enable circuit, and 8 parallel TVCs may consume 5.8mA from a 0.8V supply in schematic simulation. Considering an ADC with 6 effective bits of resolution, such sampling scheme may contribute 7.3fJ/step whilst providing a signal gain in the range of 10-12 dB.

In accordance with various aspects of the disclosure, time domain output signals (e.g. at the output of VCDC) may enable implementing a finite impulse response (FIR) filter. Employing such a FIR filter within the VCDC may provide a further control associated with the ADC frequency response. Although typical FIR filters may operate at the ADC sampling rate or require a separate clock signal with higher frequency, approximate FIR delays may be implemented through cascading a plurality of time-domain delay stages.

In some aspects, FIR filters may be implemented using cascaded delay elements, where the time-domain representations of the input analog signal may be delayed by different amounts to sample the input analog signal at different times and then weighted and summed in order to generate the filtered output. In some examples, voltage-controlled delay elements such as current-starved inverters described may be used as the delay elements in such delay line FIR filter structures. In some cases, programmable weights may be achieved by modulating the voltage-to-time gain in each stage. In order to achieve such an implementation, placing a set of dummy devices in parallel with the main signal path delay may be conducted. Other approaches to realize programmable weights may include AC coupling the input analog signal with different bias voltages to modulate the VTC gain or placing a dummy device in series with the signal device and modulating the bias voltage to scale the relative contribution of the main input device. Therefore, delay introduced by current-starved inverters may be controlled by varying the bias current. This property may be exploited to achieve a tunable or reconfigurable FIR filter in which the tap weights (i.e. filter coefficients) are adjusted by controlling the delays of the individual taps.

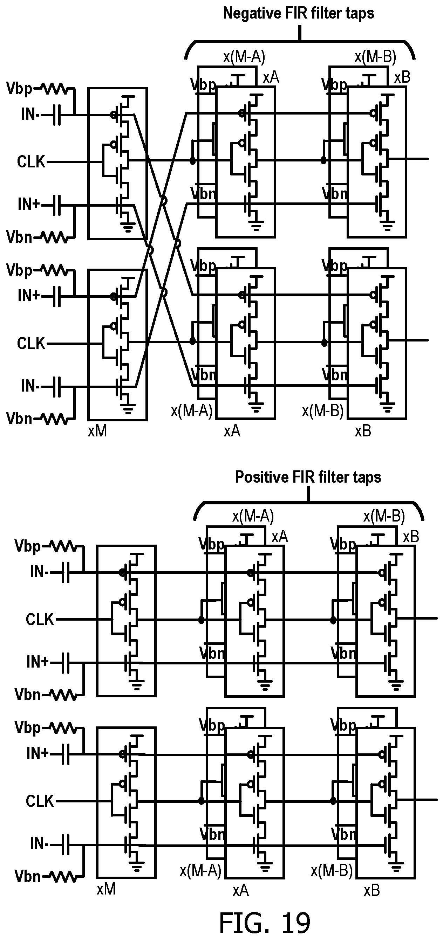

FIG. 19 shows an example of 3-tap FIR filter in accordance with various aspects disclosed herein. Such an implementation may not be attributed to a conventional FIR filter with exact delays between analog signal samples since each delay is signal-dependent and therefore notches are not likely to occur at specific frequencies at the frequency response of the VTC.

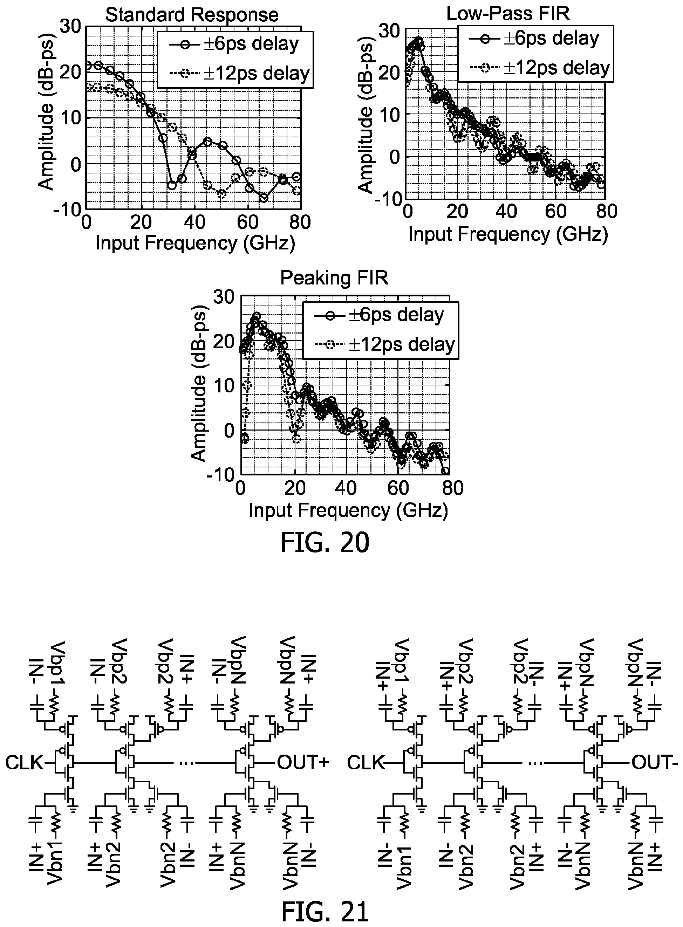

FIG. 20 shows an example of simulation results presenting a head-to-head comparison for examples of 3-tap FIR filters implemented using the scheme depicted in FIG. 19. Referring back to FIG. 19, using the weights M = 64, A = 32, B = 12 may lead to a peaking FIR response using the negative FIR filter taps in FIG. 19 and low-pass FIR response (e.g. by implementing anti-alias filter) using the positive FIR filter taps in FIG. 19. The respective frequency responses are depicted in FIG. 20 in comparison with a standard response. As shown, custom filter scheme may provide sharper attenuation of out-of-band noise than the standard integrating response.

FIG. 21 shows an example of N-tap FIR filter in accordance with various aspects disclosed herein. In such a scheme, tap weights may be adjusted using bias voltage of the input devices (i.e. current inverters / current-starved transistors). Notably, tap weights may play a significant role in determining the frequency response characteristics of a FIR filter. Such characteristics may refer to or include low-pass, high-pass, bandpass, and the like.

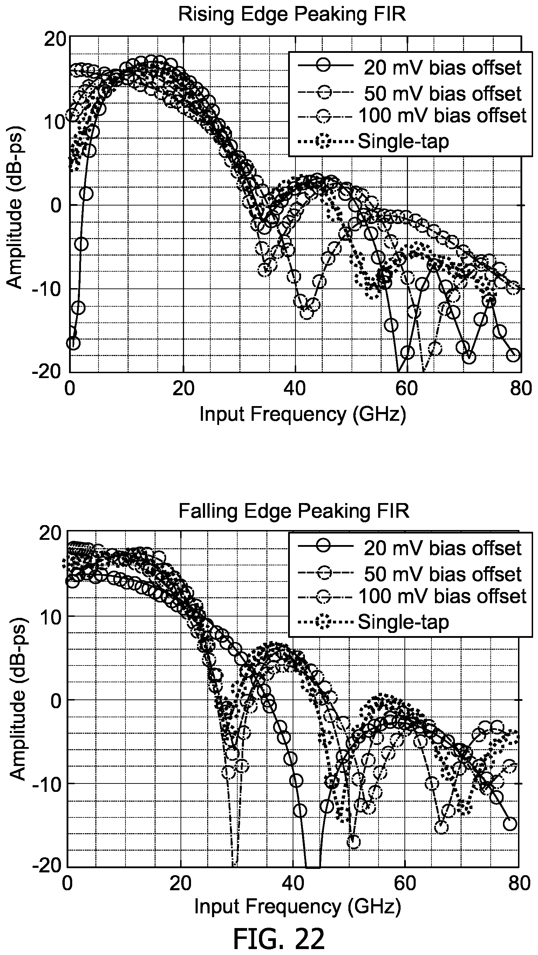

FIG. 22 shows an example of simulation results in accordance with various aspects disclosed herein. In particular, FIG. 22 depicts a variation in the frequency response as bias voltage is altered with a negative second tap for a 2-tap FIR filter. In some aspects, altered bias point may add peaking or flatten the in-band frequency response relative to the single-tap frequency response. Additionally, or alternatively, the altered bias point may provide a programmable level of low-frequency signal attenuation, which may be used to compensate for losses at high signal frequencies to provide an overall wideband frequency response.

The detailed description refers to the accompanying drawings that show, by way of illustration, specific details and aspects of this disclosure in which the disclosure may be practiced. Other aspects may be utilized and structural, logical, and electrical changes may be made without departing from the scope of the disclosure. The various aspects of this disclosure are not necessarily mutually exclusive, as some aspects of this disclosure can be combined with one or more other aspects of this disclosure to form new aspects.

The word "exemplary" is used herein to mean "serving as an example, instance, or illustration". Any aspect of the disclosure or design described herein as "exemplary" is not necessarily to be construed as preferred or advantageous over other aspects or designs.

Throughout the drawings, it should be noted that like reference numbers are used to depict the same or similar elements, features, and structures, unless otherwise noted.

The words "plurality" and "multiple" in the description or the claims expressly refer to a quantity greater than one. The terms "group (of)", "set [of]", "collection (of)", "series (of)", "sequence (of)", "grouping (of)", etc., and the like in the description or in the claims refer to a quantity equal to or greater than one, i.e. one or more. Any term expressed in a plural form that does not expressly state "plurality" or "multiple" likewise refers to a quantity equal to or greater than one.

As used herein, "memory" is understood as a non-transitory computer-readable medium in which data or information can be stored for retrieval. References to "memory" included herein may thus be understood as referring to volatile or non-volatile memory, including random access memory ("RAM"), read-only memory ("ROM"), flash memory, solid-state storage, magnetic tape, hard disk drive, optical drive, etc., or any combination thereof. Furthermore, registers, shift registers, processor registers, data buffers, etc., are also embraced herein by the term memory. A single component referred to as "memory" or "a memory" may be composed of more than one different type of memory, and thus may refer to a collective component including one or more types of memory. Any single memory component may be separated into multiple collectively equivalent memory components, and vice versa. Furthermore, while memory may be depicted as separate from one or more other components (such as in the drawings), memory may also be integrated with other components, such as on a common integrated chip or a controller with an embedded memory.

In the context of this disclosure, the term "process" may be used, for example, to indicate a method. Illustratively, any process described herein may be implemented as a method (e.g., a channel estimation process may be understood as a channel estimation method). Any process described herein may be implemented as a non transitory computer readable medium including instructions configured, when executed, to cause one or more processors to carry out the process (e.g., to carry out the method).

"The terms "at least one" and "one or more" may be understood to include a numerical quantity greater than or equal to one (e.g., one, two, three, four, [...], etc.). The term "a plurality" may be understood to include a numerical quantity greater than or equal to two (e.g., two, three, four, five, [...], etc.).The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

The words "plural" and "multiple" in the description and in the claims expressly refer to a quantity greater than one. Accordingly, any phrases explicitly invoking the aforementioned words (e.g., "plural [elements]", "multiple [elements]") referring to a quantity of elements expressly refers to more than one of the said elements. The terms "group (of)", "set (of)", "collection (of)", "series (of)", "sequence (of)", "grouping (of)", etc., and the like in the description and in the claims, if any, refer to a quantity equal to or greater than one, i.e., one or more. The terms "proper subset", "reduced subset", and "lesser subset" refer to a subset of a set that is not equal to the set, illustratively, referring to a subset of a set that contains less elements than the set.

The term "data" as used herein may be understood to include information in any suitable analog or digital form, e.g., provided as a file, a portion of a file, a set of files, a signal or stream, a portion of a signal or stream, a set of signals or streams, and the like. Further, the term "data" may also be used to mean a reference to information, e.g., in form of a pointer. The term "data", however, is not limited to the aforementioned examples and may take various forms and represent any information as understood in the art.

Unless explicitly specified, the term "transmit" encompasses both direct (point-to-point) and indirect transmission (via one or more intermediary points). Similarly, the term "receive" encompasses both direct and indirect reception. Furthermore, the terms "transmit," "receive," "communicate," and other similar terms encompass both physical transmission (e.g., the transmission of radio signals) and logical transmission (e.g., the transmission of digital data over a logical software-level connection). For example, a processor or controller may transmit or receive data over a software-level connection with another processor or controller in the form of radio signals, where the physical transmission and reception is handled by radio-layer components such as RF transceivers and antennas, and the logical transmission and reception over the software-level connection is performed by the processors or controllers. The term "communicate" encompasses one or both of transmitting and receiving, i.e., unidirectional or bidirectional communication in one or both of the incoming and outgoing directions. The term "calculate" encompasses both 'direct' calculations via a mathematical expression/-formula/relationship and 'indirect' calculations via lookup or hash tables and other array indexing or searching operations.

Throughout the drawings, it should be noted that like reference numbers are used to depict the same or similar elements, features, and structures, unless otherwise noted.

The phrase "at least one" and "one or more" may be understood to include a numerical quantity greater than or equal to one (e.g., one, two, three, four, [...], etc.). The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

As used herein, unless otherwise specified the use of the ordinal adjectives "first", "second", "third" etc., to describe a common object, merely indicate that different instances of like objects are being referred to, and are not intended to imply that the objects so described must be in a given sequence, either temporally, spatially, in ranking, or in any other manner.

As used herein, a signal that is "indicative of" a value or other information may be a digital or analog signal that encodes or otherwise communicates the value or other information in a manner that can be decoded by and/or cause a responsive action in a component receiving the signal. The signal may be stored or buffered in computer readable storage medium prior to its receipt by the receiving component and the receiving component may retrieve the signal from the storage medium. Further, a "value" that is "indicative of" some quantity, state, or parameter may be physically embodied as a digital signal, an analog signal, or stored bits that encode or otherwise communicate the value.

As used herein, a signal may be transmitted or conducted through a signal chain in which the signal is processed to change characteristics such as phase, amplitude, frequency, and so on. The signal may be referred to as the same signal even as such characteristics are adapted. In general, so long as a signal continues to encode the same information, the signal may be considered as the same signal. For example, a transmit signal may be considered as referring to the transmit signal in baseband, intermediate, and radio frequencies.

The terms "processor" or "controller" as, for example, used herein may be understood as any kind of technological entity that allows handling of data. The data may be handled according to one or more specific functions executed by the processor or controller. Further, a processor or controller as used herein may be understood as any kind of circuit, e.g., any kind of analog or digital circuit. A processor or a controller may thus be or include an analog circuit, digital circuit, mixed-signal circuit, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

As utilized herein, terms "module", "component," "system," "circuit," "element," "slice," "circuitry," and the like are intended to refer to a set of one or more electronic components, a computer-related entity, hardware, software (e.g., in execution), and/or firmware. For example, circuitry or a similar term can be a processor, a process running on a processor, a controller, an object, an executable program, a storage device, and/or a computer with a processing device. By way of illustration, an application running on a server and the server can also be circuitry. One or more circuits can reside within the same circuitry, and circuitry can be localized on one computer and/or distributed between two or more computers. A set of elements or a set of other circuits can be described herein, in which the term "set" can be interpreted as "one or more."

The term "antenna" or "antenna structure", as used herein, may include any suitable configuration, structure and/or arrangement of one or more antenna elements, components, units, assemblies and/or arrays. In some aspects, the antenna may implement transmit and receive functionalities using separate transmit and receive antenna elements. In some aspects, the antenna may implement transmit and receive functionalities using common and/or integrated transmit/receive elements. The antenna may include, for example, a phased array antenna, a single element antenna, a set of switched beam antennas, and/or the like.

It will be understood that when an element is referred to as being "connected" or "coupled" to another element, it can be physically connected or coupled to the other element such that current and/or electromagnetic radiation (e.g., a signal) can flow along a conductive path formed by the elements. Intervening conductive, inductive, or capacitive elements may be present between the element and the other element when the elements are described as being coupled or connected to one another. Further, when coupled or connected to one another, one element may be capable of inducing a voltage or current flow or propagation of an electro-magnetic wave in the other element without physical contact or intervening components. Further, when a voltage, current, or signal is referred to as being "applied" to an element, the voltage, current, or signal may be conducted to the element by way of a physical connection or by way of capacitive, electro-magnetic, or inductive coupling that does not involve a physical connection.

The following examples pertain to further aspects of this disclosure.

In example 1, the subject matter include an analog to digital converter (ADC) circuit including: a voltage-controlled delay circuit (VCDC) configured to: sample a received analog signal based on an input clock signal to generate analog signal samples; generate an output signal representative the input clock signal shifted in time domain with a delay based on the analog signal samples; a time to digital converter (TDC) coupled to the voltage-controlled delay circuit and configured to generate a digital output signal based on the output signal.

In example 2, the subject matter of example 1, wherein the VCDC is further configured to sample the received analog signal at each rising and falling edge of the input clock signal.

In example 3, the subject matter of example 1 or example 2, wherein the VCDC may further include: a current starved inverter (CSI) including: an inverter configured to receive the input clock signal and generate the output signal; a current limiter including at least one of a current source or a current sink, wherein the current limiter is configured to control a current of the inverter based on the received analog signal.

In example 4, the subject matter of example 3, may further include: wherein the CSI is a first CSI; wherein the inverter is a first inverter; wherein the current limiter is a first current limiter; wherein the output signal is a first output signal; wherein the ADC circuit further includes: a second CSI including: a second inverter configured to receive the input clock signal and output a second output signal; a second current limiter including at least one of a further current source or a further current sink, wherein the second current limiter is configured to control a current of the second inverter based on a further signal representative of an inverse of the received analog signal. In a further example, the subject matter of example may further include that the TDC is configured to generate the digital output signal based on the first output signal and the second output signal.

In example 5, the subject matter of example 4, wherein the first inverter includes: a first transistor of the first inverter and a second transistor of the first inverter, wherein the first transistor of the first inverter is of a complementary type to the second transistor of the first inverter; wherein the second inverter includes: a first transistor of the second inverter and a second transistor of the second inverter, wherein the first transistor of the second inverter is of a complementary type to the second transistor of the second inverter.

In example 6, the subject matter of any one of examples 4 to 5, wherein the VCDC further includes: a first level shifter configured to shift the received analog signal to obtain a first shifted voltage; and optionally a second level shifter configured to shift the second analog signal to obtain a second shifted voltage; wherein the first current limiter is configured to control the current of the first inverter based on the first shifted voltage and wherein the second current limiter is configured to control the current of the second inverter based on the second shifted voltage.

In example 7, the subject matter of any one of examples 3 to 6, wherein the current limiter is configured to control the current of the inverter further based on respective received control voltages to modulate voltage to time gain.

In example 8, the subject matter of example 1, may further include an inverting amplifier configured to sample the received analog signal and generate an output signal at each rising and falling edge of the input clock signal.

In example 9, the subject matter of any one of examples 1 to 8, may further include an oscillator configured to provide the input clock signal.

In example 10, the subject matter of example 9, wherein the oscillator includes at least one of a phase-locked loop (PLL), a delay locked loop, or a multi-phase clock generator.

In example 11, the subject matter of any one of examples 1 to 10, may further include one or more further VCDCs; and one or more further TDCs, each TDC of the one or more further TDCs is coupled to a respective VCDC of the one or more further VCDCs and configured to generate a respective digital output signal based on a delay between the output signal and the input clock signal.

In example 12, the subject matter of any one of examples 1 to 11, wherein the TDC includes: a time-to-voltage converter (TVC) configured to: generate a voltage based on a time difference of transitions of the output signal.

In example 13, the subject matter of example 12 may further include an analog to digital converter coupled to the TVC and configured to generate the digital output signal based on the generated voltage.

In example 14, the subject matter of example 12 or example 13, wherein the TVC includes: a first signal divider configured to divide the first output signal by N to obtain first N multi-phase output signals; a second signal divider configured to divide the second output signal by N to obtain second N multi-phase output signals; N number of samplers; wherein each sampler is configured to receive a respective first multi-phase output signal of the first N multi-phase output signals and a respective second multi-phase output signal of the second N multi-phase output signals.

In example 15, the subject matter of any one of examples 1 to 14, wherein the VCDC further includes a finite impulse response (FIR) filter including a plurality of cascaded CSIs, each cascaded CSI of the plurality of cascaded CSIs is configured to introduce a respective programmable delay to a respective input signal received from a previous cascaded CSI.

In example 16, the subject matter of example 16, wherein each cascaded CSI is configured to control the respective programmable delay by adjusting a voltage-to-time gain of the cascaded CSI.

In example 17, the subject matter of any one of examples 15 to 17, wherein the FIR filter is configured to produce an output including a first FIR filter output signal and a second FIR filter output signal; wherein the TDC is configured to generate a digital output signal based on the first FIR filter output signal and the second FIR filter output signal.

While the invention has been particularly shown and described with reference to specific embodiments, it should be understood by those skilled in the art that various changes in form and detail may be made therein without departing from the scope of the invention as defined by the appended claims. The scope of the invention is thus indicated by the appended claims and all changes which come within the meaning of the claims are therefore intended to be embraced.

**Claims**

1.  An analog to digital converter (ADC) circuit comprising:
    a voltage-controlled delay circuit (VCDC) configured to:

    sample a received analog signal based on an input clock signal to generate analog signal samples;
    generate an output signal representative of the input clock signal shifted in time domain with a delay based on the analog signal samples; and
    a time to digital converter (TDC) coupled to the voltage-controlled delay circuit and configured to generate a digital output signal based on the output signal.

2. The ADC circuit of claim 1, wherein the VCDC is further configured to sample the received analog signal at each rising and falling edge of the input clock signal.

3. The ADC circuit of any one of claims 1 or 2, further comprising:
   a current starved inverter (CSI) comprising:

   an inverter configured to receive the input clock signal and produce the output signal; and
   a current limiter comprising at least one of a current source or a current sink, wherein the current limiter is configured to control a current of the inverter based on the received analog signal.

4. The ADC circuit of claim 3,
   wherein the CSI is a first CSI, wherein the inverter is a first inverter, wherein the current limiter is a first current limiter, wherein the output signal is a first output signal, and wherein the ADC circuit further comprises:

   a second CSI comprising:
   a second inverter configured to receive the input clock signal and output a second output signal; and
   a second current limiter comprising at least one of a further current source or a further current sink, wherein the current limiter is configured to control a current of the second inverter based on a further signal representative of an inverse of the received analog signal;
   preferably wherein the time to digital converter (TDC) is configured to generate the digital output signal based on the first output signal and the second output signal.

5. The ADC circuit of claim 4,
   wherein the first inverter comprises:

   a first transistor of the first inverter and a second transistor of the first inverter, wherein the first transistor of the first inverter is of a complementary type to the second transistor of the first inverter; and
   wherein the second inverter comprises:
   a first transistor of the second inverter and a second transistor of the second inverter, wherein the first transistor of the second inverter is of a complementary type to the second transistor of the second inverter.

6. The ADC circuit of any one of claims 4 or 5,
   wherein the VCDC further comprises:

   a first level shifter configured to shift the received analog signal to obtain a first shifted voltage; and
   a second level shifter configured to shift the further signal to obtain a second shifted voltage, wherein the first current limiter is configured to control the current of the first inverter based on the first shifted voltage and wherein the second current limiter is configured to control the current of the second inverter based on the second shifted voltage.

7. The ADC circuit of any one of claims 3 to 6,
   wherein the VCDC further comprises:
   a level shifter configured to shift the received analog signal to obtain a shifted voltage, wherein the current limiter is configured to control the current of the inverter based on the shifted voltage.

8. The ADC circuit of any one of claims 3 to 7,

   wherein the current limiter is configured to control the current of the inverter further based on respective received control voltages to modulate voltage to time gain;
   preferably wherein the oscillator comprises at least one of a phase-locked loop (PLL), a delay locked loop, or a multi-phase clock generator.

9. The ADC circuit of any one of claims 1 to 8, further comprising:
   an inverting amplifier configured to sample the received analog signal and generate an output signal at each rising and falling edge of the input clock signal.

10. The ADC circuit of any one of claims 1 to 9,
    further comprising an oscillator configured to provide the input clock signal.

11. The ADC circuit of any one of claims 1 to 10,
    further comprising:

    one or more further VCDCs; and
    one or more further TDCs, each TDC of the one or more further TDCs coupled to a respective VCDC of the one or more further VCDCs and configured to generate a respective digital output signal based on a delay associated with the output signal.

12. The ADC circuit of any one of claims 1 to 11,
    wherein the TDC comprises a time-to-voltage converter (TVC) configured to:

    generate a voltage based on a time difference of transitions of the output signal;
    preferably the ADC circuit further comprising an analog to digital converter coupled to the TVC and configured to generate the digital output signal based on the generated voltage.

13. The ADC circuit of claim 12,

    wherein the TVC comprises:
    a signal divider configured to divide the output signal by N to obtain N multi-phase output signals;
    the ADC circuit further comprising:
    N number of samplers, wherein each sampler is configured to receive a respective multi-phase output signal of the N multi-phase output signals.

14. The ADC circuit of any one of claims 1 to 13,

    wherein the VCDC further comprises a finite impulse response (FIR) filter comprising a plurality of cascaded CSIs, each cascaded CSI of the plurality of cascaded CSIs is configured to introduce a respective programmable delay to a respective input signal received from a previous cascaded CSI;
    preferably wherein each cascaded CSI is configured to control the respective programmable delay by adjusting a voltage-to-time gain of the cascaded CSI.

15. The ADC circuit of claim 14,

    wherein the FIR filter is configured to produce an output including a first FIR filter output signal and a second FIR filter output signal; and
    wherein the TDC is configured to generate a digital output signal based on the first FIR filter output signal and the second FIR filter output signal.

FIG. 1

FIG. 2

300

CLK

S1

Vin

Vout

Voltage Domain
ADC
301

Dout

Cs

## FIG. 3

400

410

420

430

VTC 401

TDC 402

## FIG. 4

500

$V_{dd}$

Vclk

Q3

Q2

Vin

Q1

## FIG. 5

FIG. 6A

FIG. 6B

FIG. 7

FIG. 8

FIG. 9

FIG. 10

FIG. 11

EP 4 672 613 A2

FIG. 12A

FIG. 12B

FIG. 12C

SNDR = 42.3 db (6.73b), SFDR = 47.8, 18.7 ps/pp

FIG. 13A

SNDR = 44.1 db (7.03b), SFDR = 58.7, 15.8 ps/pp

FIG. 13B

Simulated frequecy response vs. RMS delay swing

FIG. 14A

Simulated BW vs. delay swing

FIG. 14B

1500

VCDC 1510

TVC 1520

Voltage domain ADC 1530

$V_{IN}$

CLK

$D_{OUT}$

FIG. 15

1600

1610

1630

1620

Falling edge sampler

Rising edge sampler

IN-

CLK

IN+

$V_{MID+}$

$C_L$*

$V_{1-}$

$V_{1+}$

RST

$C_{S+}$

$V_{2F-}$

$V_{2F+}$

*Parasitic capacitance only

FIG. 16

1710

1730

1720

Sampler N-1

Sampler 0

$V_{1-}$
$V_{1+}$

Divide-by-N

RST

$V_{2-}[0]$
$V_{2+}[0]$

$C_{S+}$

× N

## FIG. 17A

1740

1760

1720

CLK

DIV[0] DIV[1] DIV[2] DIV[3]

Reset

SET
D Q

RST
D Q

RST
D Q

RST
D Q

CLK

Q D
RST

Q D
RST

Q D
RST

Q D
RST

DIV[7] DIV[6] DIV[5] DIV[4]

DIV[7]
DIV[6]
DIV[5]
DIV[4]
DIV[3]
DIV[2]
DIV[1]
DIV[0]

Sampler N-1

Sampler 0

$V_{1-}$
$V_{1+}$

RST

$V_{2-}[0]$
$V_{2+}[0]$

$C_{S+}$

× N

Divide-by-N

1750

## FIG. 17B

SNDR = 40.7 dB (6.46b), SFDR = 49.8, 247 mV pp

SNDR = 39.7 dB (6.30b), SFDR = 45.1, 326 mV pp

FIG. 18

FIG. 19

FIG. 20

FIG. 21

Rising Edge Peaking FIR

Falling Edge Peaking FIR

FIG. 22